(19) Europäisches Patentamt / European Patent Office / Office européen des brevets

(11) **EP 4 107 119 B1**

(12) **EUROPÄISCHE PATENTSCHRIFT**

(45) Veröffentlichungstag und Bekanntmachung des Hinweises auf die Patenterteilung:
**01.04.2026 Patentblatt 2026/14**

(21) Anmeldenummer: **21707233.9**

(22) Anmeldetag: **19.02.2021**

(51) Internationale Patentklassifikation (IPC):
**B81C 1/00** *(2006.01)*

(52) Gemeinsame Patentklassifikation (CPC):
**B81C 1/00293; B81C 1/00317;** B81B 2201/0214;
B81B 2201/058; B81C 2203/031; B81C 2203/036

(86) Internationale Anmeldenummer:
**PCT/EP2021/054179**

(87) Internationale Veröffentlichungsnummer:
**WO 2021/165478 (26.08.2021 Gazette 2021/34)**

(54) **HERMETISCH VERSCHLOSSENE GLASUMHÄUSUNG**

HERMETICALLY SEALED GLASS ENCLOSURE

ENCEINTE EN VERRE HERMÉTIQUEMENT SCELLÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.02.2020 DE 102020104613**

(43) Veröffentlichungstag der Anmeldung:
**28.12.2022 Patentblatt 2022/52**

(73) Patentinhaber: **SCHOTT AG**
**55122 Mainz (DE)**

(72) Erfinder:
• **THOMAS, Jens Ulrich**
**55128 Mainz (DE)**
• **DAMM, Thorsten**
**65343 Eltville am Rhein (DE)**
• **ZETTERER, Thomas**
**84034 Landshut (DE)**

(74) Vertreter: **Blumbach · Zinngrebe Patentanwälte PartG mbB**
**Alexandrastraße 5**
**65187 Wiesbaden (DE)**

(56) Entgegenhaltungen:
EP-A1- 2 778 121      WO-A1-2008/103338
DE-A1- 10 235 372     DE-A1- 102004 043 120

## Beschreibung

Gebiet der Erfindung

Die Erfindung betrifft eine Umhäusung zur Kapselung eines Funktionsbereichs gegen eine Umgebung sowie ein Verfahren zum Bereitstellen einer solchen Glasumhäusung.

Hintergrund und allgemeine Beschreibung der Erfindung

Umhäusungen, die insbesondere hermetisch verschlossen werden können, können beispielsweise dafür eingesetzt werden, sensible Elektronik, Schaltkreise, optische und optoelektronische Bauteile (z.B. OLEDs) oder auch Sensoren zu schützen. So können medizinische Implantate, beispielsweise im Bereich des Herzens, in der Retina oder für Bio-Prozessoren eingesetzt werden. Es sind Bio-Prozessoren bekannt, welche aus Titan angefertigt und eingesetzt werden. Andererseits lässt sich in einer Umhäusung auch ein Medikament oder anderes, insbesondere hermetisch versiegelt, einpacken. Im Körper eingepflanzt können diese Implantate dann Medikamente über einen längeren Zeitraum exakt dosiert abgeben.

Sensoren können mit einer erfindungsgemäßen Umhäusung für besonders widrige Umweltbedingungen geschützt werden. In diesen Bereich fallen beispielsweise auch MEMS (Mikro-Elektro-Mechanische-Systeme), Barometer, Blutgassensor, Glukosesensor, usw. Ein weiteres Feld für den Einsatz einer erfindungsgemäßen Umhäusung kann auch in einer Hülle für ein Smartphone, im Bereich von Virtual Reality-Brillen und ähnlichem Gerät angesiedelt sein. Eine erfindungsgemäße Umhäusung kann auch für die Herstellung von Flusszellen bspw. im Rahmen der Elektromobilität zum Einsatz kommen. Aber auch in der Luft- und Raumfahrt, in Hochtemperaturanwendungen und im Bereich der Mikrooptik sind erfindungsgemäße Umhäusungen einsetzbar.

Den vorgenannten Einsatzzwecken ist gemein, dass widrige Einsatzbedingungen herrschen, und somit an die Bauteile hohe Anforderungen hinsichtlich ihrer Robustheit gestellt werden, als wenn diese ungeschützt diesen Umwelteinflüssen ausgesetzt wären. Um auch den Einsatz von solchen Bauteilen zu ermöglichen, die erwartbar diesen äußeren Einflüssen nicht standhalten, kann eine Umhäusung eingesetzt werden, um diese Bauteile vor solchen widrigen Umwelteinflüssen zu schützen.

Darüber hinaus ist ggf. die Anforderung gestellt, dass ein Austausch mit dem Innenbereich der Umhäusung, also beispielsweise einer von der Umhäusung gebildeten Kavität, also beispielsweise mit elektromagnetischer Strahlung insbesondere im sichtbaren Bereich und/oder im Bereich der Mikrowellenstrahlung, gewährleistet ist, also die Umhäusung zumindest teilweise - d.h.

zumindest bereichsweise und/oder zumindest für einen Wellenlängenbereich - transparent ist. Diese Transparenz erlaubt Kommunikationsverfahren, Daten- oder Energieübertragung, Messungen von und mit der in der Kavität angeordneten Elektronik bzw. Sensor. Es können insbesondere optische Kommunikationsverfahren bzw. optische Daten- oder Energieübertragung ermöglicht sein.

Es ist grundsätzlich bekannt, mehrere Teile zusammenzufügen und diese Teile so anzuordnen, dass in einem Zwischenraum ein Aufnahmebereich entsteht, in welchem Komponenten beherbergt werden können. Beispielsweise zeigt EP 3 012 059 B1 ein Verfahren zur Herstellung eines transparenten Teils zum Schützen eines optischen Bauteils. Es wird dabei ein neuartiges Laser-Verfahren eingesetzt.

Die internationale Patentanmeldung WO 2008/103338 A1 beschreibt hermetisch dichte Umhäusungen, bei welchen zur Fügung von deren Bestandteilen eine durch einen Hochleistungslaser erwärmte Fritte verwendet wird. DE 102 35 372 A1 offenbart ein Bauelement mit einer Siliziumlage und einer weiteren Lage aus Silizium oder Glas, wobei die Lagen fügeschichtfrei mittels einer Laserverschweißung verbunden sind. In der Siliziumlage ist eine oberflächenmikromechanische Struktur hergestellt und in der weiteren Lage eine dazu komplementäre Kavernenstruktur, wobei die Lagen so zusammengefügt sind, das mindestens die oberflächenmikromechanischer Struktur von der Kavernenstruktur der weiteren Lage abgedeckt ist.

Nun ist im Rahmen der vorliegenden Weiterentwicklung von erfindungsgemäßen Umhäusungen problematisiert worden, dass die zum Bilden einer Umhäusung eingesetzten Materialien eine von Null verschiedene Permeabilität aufweisen. Daher können sowohl in der Kavität eingeschlossene Gase oder Flüssigkeiten nach außen aus der Umhäusung herausdringen oder solche Stoffe bzw. Fluide aus der Umgebung in die Umhäusung eindringen. Beispielsweise kann dies durch einen Konzentrationsgradienten, also dem Aufbau eines osmotischen Drucks, oder in Druckdifferenzen begründet sein. Je undurchlässiger ein Umhäusungsmaterial ist, desto länger ist die Durchdringungszeit, die ein entsprechender Stoff bzw. Fluid benötigt, um das Material der Umhäusung zu durchdringen.

Zwar liegen für Glas die erwarteten Zeitkonstanten in einer Größenordnung von Jahren, dies kann aber insbesondere für Produkte mit einer langen Lebensdauer, wie bei Implantaten oder bei Medizinverpackungen, relevant sein.

Als Maß für die Berechnung von Zeitkonstanten bei vorgegebenen Materialien, Geometrien und Umgebungsbedingungen gilt zum Beispiel die Konzentration an Verunreinigung eines zu Beginn reinen Gases in einer Kavität nach einer bestimmten Zeit. Beispielsweise kann dies für den Fall von einfachen Elektroniken ein zu unterschreitender Wert von 5000 ppm in einem hermetisch geschlossenen Gehäuse sein. Dies kann insbesondere Wasserdampf sein. Für andere Anwendungsfälle bzw. Gase oder Fluide können auch andere einzuhaltende Grenzen definiert werden.

Bei der Wahl des Materials für die Umhäusung spielten bislang zunächst im Wesentlichen die Faktoren Kosten, Festigkeit, CTE, Formbarkeit und die Inertheit gegenüber eingeschlossenen Substanzen die größte Bedeutung. Da die bereits von der Anmelderin gefundenen hervorragenden Materialien nach und nach auch für weitere Anwendungsbereiche, beispielsweise langlebige Implantate, einsetzbar werden sollen, hat sich die Erfindung die Aufgabe gestellt, eine verbesserte Umhäusung bereitzustellen, die die vorgenannten wichtigen Faktoren nur unwesentlich beeinträchtigt.

Die vorliegende Erfindung beschäftigt sich daher in dem Rahmen, dass Umhäusungen verbessert und insbesondere widerstandsfähiger aufgebaut werden. Mit anderen Worten beschäftigt sich also die vorliegende Erfindung damit, eine verbesserte Umhäusung bereitzustellen, und ein Weg dahin wurde insbesondere darin gefunden, die Permeation des Gehäusematerials zu verbessern.

Eine erfindungsgemäße Umhäusung zur Kapselung eines Funktionsbereichs gegen eine Umgebung umfasst dabei ein Basissubstrat und ein Abdecksubstrat, wobei das Basissubstrat zusammen mit dem Abdecksubstrat zumindest einen Teil der Umrüstung oder die Umhäusung bildet. Ferner ist zumindest ein von der Umhäusung umschlossener Funktionsbereich in der Umhäusung angeordnet. Der Funktionsbereich wird insbesondere von der Umhäusung hermetisch verschlossen.

Die erfindungsgemäße Umhäusung weist ferner eine Sperreinrichtung auf zur Verringerung der Permeation zwischen der Umgebung und dem Funktionsbereich. Erfindungsgemäß umfasst eine solche Sperreinrichtung eine Sperrschicht, welche um den Funktionsbereich herum angeordnet ist.

Das hermetische Verschließen der Umhäusung erfolgt mit einem von SCHOTT entwickelten Laserfügeverfahren. Ergänzend können je nach Anwendungsanforderungen auch andere Verfahren für die Glas-Glas-Verbindung genutzt werden; Dies sind zum Beispiel: Anodisches Bonden, Glas-Frit-Bonden oder Aufschmelzen mittels $CO_2$-Laser. Im Folgenden wird stellvertretend das Laserfügen für Anwendungsbeispiele ausgeführt, weil eine erfindungsgemäße Umhäusung zumindest eine Laserbondlinie aufweist und die Substrate der erfindungsgemäßen Umhäusung mittels der zumindest einen Laserbondlinie hermetisch dicht miteinander gefügt sind.

Die erfindungsgemäße Umhäusung ist in Anspruch 1 angegeben und weist zumindest eine Laserbondlinie auf, so dass die Substrate der Umhäusung mittels der zumindest einen Laserbondlinie hermetisch dicht miteinander gefügt sind. Jede Laserbondlinie weist dabei bevorzugt eine Höhe HL senkrecht zu seiner Verbindungsebene auf. In bevorzugter Weise reicht die Laserbondlinie mit der Höhe HL in das Material des oberhalb der Laserbondlinie angeordneten Substrats hinein. Gegenüberliegend reicht die Laserbondlinie in das Material des unter der Laserbondlinie liegenden Substrats hinein. Mit anderen Worten reicht die Laserbondlinie in die beiden Substrate hinein, die miteinander gefügt werden sollen bzw. die miteinander mittels der Laserbondlinie gefügt sind.

Beispielsweise wird das Abdecksubstrat mit dem Basissubstrat schmelzend miteinander gefügt.

Mit anderen Worten vermischt sich bei dem Fügeschritt bzw. in der Laserbondlinie schmelzend Material des einen Substrats mit Material des anderen Substrats zur Herstellung des festen und nicht lösbaren hermetischen Verbunds zwischen dem einen Substrat und dem anderen Substrat. In einem anderen Beispiel ist zwischen dem Basissubstrat und dem Abdecksubstrat zunächst ein Zwischensubstrat angeordnet, wobei in diesem Beispiel das Basissubstrat mit dem Zwischensubstrat in einer ersten Verbindungsebene mittels mindestens einer ersten Laserbondlinie gefügt ist und wobei das Abdecksubstrat mit dem Zwischensubstrat in einer zweiten Verbindungsebene mit mindestens einer zweiten Laserbondlinie gefügt ist.

Die erfindungsgemäße Umhäusung weist zusätzlich eine Sperreinrichtung auf, die beispielsweise direkt um die Kavität herum angeordnet ist, um damit die Permeation der Umhäusung so zu verringern, dass eine noch längere Lebensdauer der in der Kavität angeordneten Bauteile oder Medikamente oder Beherbergungsobjekte erreicht werden kann.

Die Umhäusung umfasst bevorzugt ein zwischen dem Basissubstrat und dem Abdecksubstrat angeordnetes Zwischensubstrat, in diesem Fall weist die Umhäusung drei Schichten auf, die übereinander angeordnet sind und miteinander gefügt sind oder werden. Der Funktionsbereich der Umhäusung kann zumindest eine Kavität und/oder zumindest eine Funktionsschicht umfassen. Mit anderen Worten kann in der Umhäusung eine Kavität gebildet sein, in welcher Beherbergungsobjekte angeordnet werden können, so dass diese von der Umhäusung beherbergt und geschützt werden. Der Funktionsbereich kann alternativ oder kumulativ zumindest eine Funktionsschicht umfassen, beispielsweise eine elektrisch aktive Schicht oder eine fotoresistive Schicht oder dergleichen, beispielsweise auch eine Schicht, die mittels Einstrahlung von geeigneter Strahlung Elektrizität erzeugt, also eine fotovoltaische Schicht.

Die Sperreinrichtung der erfindungsgemäßen Umhäusung umfasst eine Sperrschicht. Die Sperrschicht umschließt den Funktionsbereich zumindest teilweise. Beispielsweise, wenn das erste Substrat ein anderes Material aufweist als das zweite Substrat, kann es ausreichend sein, die Kavität bzw. den Funktionsbereich lediglich gegen eines der beiden Substrate zu schützen bzw. zu sperren. Die Sperrschicht kann eine Beschichtungslage umfassen, mit anderen Worten kann die Sperrschicht als Beschichtung auf jedenfalls eines der Substrate aufgetragen sein, beispielsweise aufgedampft, so dass dieses Substrat mittels der Sperrschicht eine verringerte Permeabilität erhält.

Die Sperrschicht ist somit insbesondere an zumindest einem aus Basissubstrat und/oder Abdecksubstrat und/oder Zwischensubstrat angeordnet. Ferner ist die Sperrschicht bevorzugt an einer zum Funktionsbereich hin ausgerichteten Innenseite angeordnet.

Die Sperrschicht kann den Funktionsbereich unmittelbar umschließen, d. h. die Sperrschicht bildet jedenfalls einen Teil der umlaufenden Innenwände des Funktionsbereiches bzw. der Kavität. Die Sperrschicht kann den Funktionsbereich beispielsweise zu zumindest einem der Substrate hin umschließen oder aber den Funktionsbereich vollständig zu allen Seiten hin umschließen.

Das Basissubstrat der Umhäusung besteht bevorzugt aus einem Material niedriger Permeabilität. Das Abdecksubstrat kann ein Material umfassen, welches eine höhere Permeabilität aufweist als das Basissubstrat. Dies kann einen typischen Fall für den Aufbau einer Umhäusung darstellen, in welchem eine Kavität in dem Basissubstrat eingebracht bzw. eingebaut wird und die Kavität durch das Auflegen bzw. Aufsetzen des Abdecksubstrats verschlossen wird. Das aufgelegte bzw. aufgesetzte Abdecksubstrat kann dabei ein anderes Material sein, welches insbesondere andere optische Eigenschaften aufzuweisen hat als das Basissubstrat. So ist es typischerweise vorgesehen, die Laserbondlinie von oberhalb des Stapels von Substraten, also den übereinander angeordneten Wafern zum Beispiel, die später die Umhäusung bilden werden, mit einem Laser einzustrahlen, um die Laserbondlinien in die Umhäusung einzubringen. Der Laser muss also das Abdecksubstrat durchdringen können, es ist hingegen nicht notwendig, dass der Laser das Basissubstrat zu durchdringen vermag.

Damit kann für das Abdecksubstrat ein anderes Material eingesetzt werden, als für das Basissubstrat, welches ggf. Eigenschaften aufweist, die das Basissubstrat nicht aufweist und anders herum. Gegebenenfalls ist in einer solchen Anordnung lediglich das Abdecksubstrat hinsichtlich der Permeation mittels der Sperreinrichtung zu verbessern.

Als Material für das bzw. die Substrate können beispielsweise solche eingesetzt werden, welche bevorzugt biokompatibel sind bzw. chemisch gut beständige oxidische Materialien. So können die Substrate, d.h. das Abdecksubstrat, das Zwischensubstrat und/oder das Basissubstrat, Silizium basierte Oxide und/oder Nitride umfassen, bevorzugt $SiO_2$ und/oder $Si_3N_4$ oder/und auch Aluminium basierte Oxide und/oder Nitride umfassen, bevorzugt $Al_2O_3$ und/oder AIN. Neben Glas werden daher auch polykristalline Wafer aus $Al_2O_3$ bevorzugt, kristallisierte Oxide oder Poly-Silizium. Solche Materialien weisen bereits eine hohe Sperrfunktionalität auf. Beispielsweise kann das Abdecksubstrat zumindest eines der vorgenannten Materialien umfassen, wobei das Basissubstrat ein davon verschiedenes Substratmaterial umfasst bzw. im Wesentlichen aus einem davon verschiedenen Substratmaterial aufgebaut ist. In diesem Fall ist es sinnvoll, das Basissubstrat zusätzlich mittels der Sperreinrichtung hinsichtlich der Permeabilität zu verbessern.

Die Sperreinrichtung kann zu diesem Zweck beispielsweise ebenfalls ein Material oder einen Materialmix aufweisen, welcher bevorzugt biokompatibel ist bzw. chemisch gut beständige oxidische Materialien. So kann die Sperreinrichtung bzw. die Sperreinrichtungen Silizium basierte Oxide und/oder Nitride und oder Oxinitride umfassen, bevorzugt $SiO_2$ und/oder $Si_3N_4$ oder/und auch Aluminium basierte Oxide und/oder Nitride oder Oxinitride umfassen, bevorzugt $Al_2O_3$ und/oder AIN. Des Weiteren kann eine Sperrschicht auch Oxide, Nitride oder Oxinitride auf Basis von Silizium und Aluminium, also $SiAl_xN_y$, $SiAl_xO_y$ oder $SiAl_xO_yN_z$ umfassen. Als Sperreinrichtung kann auch eine dünne Schicht fungieren, die mit dem dazu benachbarten Substrat hermetisch verbunden bzw. gefügt ist. Die Sperreinrichtung kann ein Metallmaterial umfassen, und/oder $Si_3N_4$ oder $SiO_xN_y$ (Siliziumoxinitrid), insbesondere eine daraus aufgebaute Schicht, welche beispielsweise durch Plasma Enhanced Chemical Vapor Deposition (PECVD) oder Sputtertechnologie oder Atomlagenabscheidung (ALD) abgeschieden werden kann. Die Sperreinrichtung kann beispielsweise eine Dicke von 1 μm oder kleiner aufweisen, weiter bevorzugt 500 nm oder kleiner, weiter bevorzugt 100nm oder kleiner, besonders bevorzugt 50 nm oder kleiner. Die Sperrschicht bzw. Sperreinrichtung kann auch 30 nm oder dünner ausgestaltet sein, um die erfindungsgemäße Wirkung zu erzielen.

Die Sperreinrichtung vermag dabei die Permeabilität zwischen Funktionsbereich und Umgebung um mindestens 30 % zu verringern. Mit anderen Worten hat die Sperreinrichtung den Einfluss auf das Substratmaterial des Substrats, auf welchem es als Sperrschicht angeordnet bzw. aufgetragen ist, die Permeabilität dieses Substrats um beispielsweise mindestens 30 % zu verringern d. h. zu verbessern.

Die Sperrschicht kann so eingerichtet sein, die Permeabilität in beiden Durchdringungsrichtungen durch die Umhäusung herabzusetzen. Das bedeutet, dass die Sperrschicht sowohl die Permeabilität für ein in der Kavität eingeschlossenes Gas, Stoff oder gasförmigen Gemisches hinsichtlich des Austritts in die Umgebung herabsetzt und auch die Permeabilität für ein in der Umgebung befindliches Gas, einen Stoff oder ein gasförmiges Gemisch hinsichtlich der Durchdringung in die Kavität hinein.

Die Sperreinrichtung kann ferner eine zweite Sperrschicht aufweisen. Der Funktionsbereich kann dabei zwischen der ersten Sperrschicht und der zweiten Sperrschicht angeordnet sein. Beispielsweise kann die erste Sperrschicht auf dem Abdecksubstrat angebracht oder aufgetragen sein, die zweite Sperrschicht kann dann auf dem Basissubstrat angeordnet oder aufgebracht sein, so dass der Funktionsbereich allseits mit der ersten und zweiten Sperrschicht umschlossen ist. Bevorzugt sind die Sperrschichten auf den zum Funktionsbereich hin ausgerichteten Seiten angeordnet.

Die zweite Sperrschicht kann auch auf der ersten Sperrschicht angeordnet oder aufgetragen sein, so dass die beiden Sperrschichten in derselben Richtung ihre Wirkung ergänzen. Damit kann je nach Auswahl des Materials der Sperrschicht ein differenzierter Schutz hinsichtlich selektierter Materialien erzielt werden. So kann eine Schicht der Sperreinrichtung $SiO_2$ umfassen und die zweite Schicht $SI_3N_4$, so dass ein sich ergänzender Schutz durch den Auftrag von beiden Sperrschichten an derselben Seite der Kavität erreicht wird.

Das Basissubstrat, das eine oder die mehreren Zwischensubstrate und/oder das Abdecksubstrat können ein glasartiges Material umfassen. Dies kann beispielsweise Glas sein oder Glaskeramik, Silizium, Aluminiumoxid, Saphir oder eine Kombination der vorgenannten Materialien. Insbesondere Glas bzw. glasartige Materialien haben sich als besonders vorteilhaft erwiesen, da diese sehr gut bioverträglich sind, d. h. chemisch kompatibel mit dem menschlichen Körper sind, keine Wechselwirkungen mit dem menschlichen Organismus bekannt sind und Glas zugleich hervorragende Isolationseigenschaften bereitstellt. Des Weiteren kann Glas transparent für Strahlung hergestellt werden, so dass beispielsweise ein kabelloser Informationsaustausch über Strahlung bzw. Welleninformation gewährleistet werden kann oder aber das kontaktlosen Laden von gegebenenfalls in der Umhäusung angeordneter Elektronik oder Batterien. Handelt es sich bei einem Substrat - insbesondere dem Abdecksubstrat - um ein im optischen Wellenlängenbereich durchlässiges Substrat, also beispielsweise ein optisch transparentes Substrat, kann eine Energiezufuhr in die Umhäusung auf optischem Weg realisiert werden, beispielsweise mittels einer in der Umhäusung angeordneten Fotovoltaikzelle oder einem andersartigen optischen Rezeptor zur Bereitstellung von elektrischer Energie. Die Umhäusung kann dann als autarke Umhäusung beschrieben werden. Zur Herstellung des hermetischen Verschlusses, insbesondere um den Funktionsbereich herum, kann insbesondere eine der Laserbondlinien den Funktionsbereich in einem Abstand DF umlaufend umschließen. In einem Beispiel ist der Abstand DF umlaufend um den Funktionsbereich konstant, so dass die Laserbondlinie allseits im ungefähr gleichen Abstand um den Funktionsbereich herumliegt. Der Abstand DF kann je nach Anwendungsfall aber auch schwanken. Dies kann produktionstechnisch günstiger sein, wenn eine Mehrzahl von Umhäusungen zugleich in einem Arbeitsschritt gefügt wird und beispielsweise gerade Fügelinien bzw. Laserbondlinien an den jeweiligen Kontaktflächen der einzelnen Umhäusungen geführt werden. Dies kann auch der Fall sein, wenn der Funktionsbereich bzw. die Umhäusung beispielsweise rund ist oder eine beliebige Form aufweist und die Laserbondlinie, die den Funktionsbereich insbesondere hermetisch verschließt, in geraden Linien gezogen wird. In einem Beispiel kann der Funktionsbereich als Kavität ausgestaltet sein und die Kavität wiederum optische Eigenschaften aufweisen, beispielsweise in Form einer Linse, wie einer Sammellinse, ausgeformt sein und die Laserbondlinie in einem davon unterschiedlichen Muster um die Kavität herumgezogen sein.

Der Funktionsbereich der Umhäusung ist beispielsweise hergerichtet zur Aufnahme zumindest eines Beherbergungsobjekts, wie beispielsweise ein elektronischer Schaltkreis, ein Sensor oder MEMS, so dass innerhalb der Umhäusung zumindest ein Beherbergungsobjekt angeordnet ist. Bei dem Beherbergungsobjekt kann es sich um Elektronik handeln, wie einem Leistungshalbleiterchip, zum Beispiel eine GaN-LED, einen SiC-, GaAs- oder GaN-Leistungstransistor umfassen. Das Beherbergungsobjekt kann auch ein Medikament oder ein dort angeordnetes Fluid sein, welches nicht oder jedenfalls zu einem späteren oder vordefinierten Zeitpunkt mit der Umgebung reagieren soll.

Das Beherbergungsobjekt ist dabei bevorzugt in einer Kavität angeordnet, die allseits bzw. vollständig von der Umhäusung umschlossen ist. Der Funktionsbereich bzw. die Kavität kann in das Basissubstrat eingebracht sein, also indem beispielsweise aus dem Basissubstrat eine Vertiefung, beispielsweise abrasiv, ausgehöhlt ist und somit der Funktionsbereich und/oder das zumindest eine Beherbergungsobjekt unten und seitlich von dem Material des Basissubstrats umgeben ist. Der Funktionsbereich bzw. die Kavität kann auch oberhalb des Basissubstrats angeordnet sein, beispielsweise auf dem Basissubstrat.

Die Umhäusung kann auch mehrere Kavitäten umfassen, beispielsweise zum Aufnehmen von Beherbergungsobjekten in unterschiedlichen Kavitäten. Beispielsweise kann hierdurch eine gegebenenfalls installierte Batterie bzw. Speicherzelle von weiteren Bauteilen getrennt in der Umhäusung beherbergt werden. Beispielsweise kann auch ein Medikament in einer ersten Kavität und eine Steuer- oder Abgabeelektronik, wie eine Zeitschalt-Elektronik, in einer zweiten Kavität angeordnet sein und einen kontrollierten Auslass des Medikaments, beispielsweise zu einem bestimmten Zeitpunkt oder bei Eintritt eines bestimmten Ereignisses, in die Umgebung steuern.

Die Umhäusung kann Glasdurchführungen aufweisen, beispielsweise in einem zumindest zwei Kavitäten trennenden Zwischensubstrat. Diese Glasdurchführungen können die in verschiedenen Kavitäten angeordneten Beherbergungsobjekte miteinander elektrisch verbinden. Bei den Glasdurchführungen kann es sich um in "Through Glass Via" (TGV) handeln, wobei die Via mit elektrisch leitendem Material gefüllt werden. Die Umhäusung kann auch eine elektrische Verbindungsschicht aufweisen, welche beispielsweise auf einem Zwischensubstrat angeordnet werden kann. Dann ist es besonders einfach, die Bauteile bzw. Beherbergungsobjekte in der jeweiligen Kavität anzuordnen und elektrisch zu verbinden. Die elektrische Verbindungsschicht ist beispielsweise an einer Unterseite der Kavität bzw. Kavitäten angeordnet und kann mit Glasdurchführungen kontaktiert sein.

Ein Beispiel für einen Funktionsbereich, der nicht als Kavität ausgebildet ist, ist die Aufbringung einer elektrischen Verbindungsschicht auf einem Substrat, wodurch bereits ein Funktionsbereich ohne Hohlraum gebildet wird. Eine solche elektrische Verbindungsschicht kann beispielsweise zwei andere Funktionsbereiche elektrisch miteinander verbinden, beispielsweise zwei Kavitäten.

Ein Substrat kann auch mehrere Schichten umfassen und somit ein Mehrschichtverbund sein. So ein Mehrschichtverbund kann dann als eine der Schichten der Umhäusung mit dem oder den anderen Substraten mittels des Laserfügeverfahrens verbunden werden. Dies kann also bedeuten, dass der Mehrschichtverbund im Vorhinein vorbereitet wird, beispielsweise indem eine Beschichtung auf einem Substrat aufgetragen wird und so ein Zweischichtverbund hergestellt wird, und dieser Zweischicht- bzw. Mehrschichtverbund als Ganzes mit der oder den anderen Schichten im Herstellungsprozess der Umhäusung verbunden wird zur Herstellung der Umhäusung.

Durch den Einsatz eines Mehrschichtverbunds in der Umhäusung können der Umhäusung weitere Materialeigenschaften hinzugefügt werden, die beim Einsatz von Einschichtsubstraten so nicht erreichbar wären. Beispielsweise kann der Mehrschichtverbund bereits eine innere Spannung oder Vorspannung aufweisen bzw. eine Vorspannungsrichtung, so dass bei dem Laserfügen des Mehrschichtverbunds mit der zumindest einen weiteren Schicht der Umhäusung der innere Spannungsbetrag verbessert werden kann. Beispielsweise kann dies die Widerstandsfähigkeit der Umhäusung verbessern, wenn ein im Vorhinein gehärteter Mehrschichtverbund eingesetzt wird. Dies kann darin resultieren, dass die Umhäusung als Ganzes die Eigenschaften einer gehärteten Umhäusung annimmt.

Zusätzlich oder alternativ kann der Mehrschichtverbund eine oder mehrere Beschichtungslagen aufweisen, also beispielsweise eine solche Beschichtung, die möglicherweise Anlass für Komplikationen gibt, wenn diese Schicht mittels des Laserfügeverfahrens gefügt werden müsste. Mit anderen Worten ist ein Substrat, welches als Mehrschichtverbund bereitgestellt wird, als "Pack" oder "Stapel" bereitgestellt mit Schichten, die bereits miteinander verbunden sind.

Zum Fügen können je nach Anwendungsanforderungen auch andere Verfahren als das Laserfügeverfahren für die Glas-Glas-Verbindung genutzt werden. Dies sind zum Beispiel: Anodisches Bonden, Glas-Frit-Bonden oder Aufschmelzen mittels $CO_2$-Laser. Im Folgenden wird stellvertretend das Laserfügen für Anwendungsbeispiele ausgeführt, denn eine erfindungsgemäße Umhäusung weist zumindest eine Laserbondlinie auf und die Substrate der erfindungsgemäßen Umhäusung sind mittels der zumindest einen Laserbondlinie hermetisch dicht miteinander gefügt. Das Laserfügeverfahren kann derart lokal kontrolliert werden, dass durch den Fügevorgang nur eine geringe bzw. vernachlässigbare Wärmemenge in den Funktionsbereich bzw. in die Kavität(en) eintritt. Das Laserfügeverfahren findet somit quasi bei Raumtemperatur statt, d. h. die Umhäusung wird quasi bei Raumtemperatur gefügt.

Die Laserbondlinie reicht insbesondere mit der Höhe HL in das Material des über der Laserbondlinie angeordneten Substrats hinein. In der Laserbondlinie findet ein lokaler Aufschmelzvorgang in dem Material statt, so dass, wenn die Laserbondlinie zum Teil in ein erstes und zu einem weiteren Teil in ein zweites Substrat hineinreicht, die beiden Substrate schmelzend miteinander gefügt werden. Mit anderen Worten wird mittels der bzw. den Laserbondlinien das Basissubstrat mit dem oder den Zwischensubstraten und dem Abdecksubstrat schmelzend miteinander gefügt.

Die Laserbondlinie ist mit anderen Worten so angeordnet bzw. aufgebaut, dass sie Lücken in dem hermetischen Verschluss der Umhäusung zu überbrücken vermag, indem beispielsweise zwei Bauteile mittels der Laserbondlinie schmelzend miteinander gefügt werden. In dem Fall, dass die Umhäusung lediglich Basissubstrat und Abdecksubstrat aufweist, um den Funktionsbereich vollständig zu schließen, wird der Kontaktbereich zwischen Basissubstrat und Abdecksubstrat, also die Stelle bzw. der Bereich bzw. die Fläche, an welcher Abdecksubstrat und Basissubstrat aneinandergrenzen, mittels der Laserbondlinie überbrückt bzw. verbunden. Im Ergebnis bildet sich die Umhäusung aus, als wäre sie einstückig geformt, wobei auch die Trennstelle zwischen den Bauteilen mittels der Laserbondlinie hermetisch verschlossen ist.

Die Umhäusung ist bevorzugt zumindest teilweise und/oder bereichsweise für einen Wellenlängenbereich transparent. In einem einfachen Beispiel ist das Abdecksubstrat der Umhäusung im sichtbaren Wellenlängenbereich optisch transparent, also durchsichtig. Aber auch Transparenz beispielsweise im UV- oder IR-Bereich kann vorteilhaft sein. Mit anderen Worten umfasst beispielsweise das Abdecksubstrat bevorzugt ein nicht leitendes z.B. oxidisches oder nitridisches Material, beispielsweise ein glasartiges Material oder auch ein metallisches Glas. Das Abdecksubstrat ist dadurch bevorzugt transparent bzw. durchlässig für zumindest einen Wellenlängenbereich, beispielsweise optisch transparent. Je nach Anwendungsfall kann es auch vorteilhaft sein, wenn beispielsweise das Abdecksubstrat opak ausgebildet ist, d.h. optisch intransparent, in der Art von Milchglas oder polykristalliner Oxidkeramik. Auch eine reduzierte Transparenz bzw. Teildurchlässigkeit kann für die Funktion ausreichen.

In einer bevorzugten Ausführungsform ist das Abdecksubstrat eine Glasplatte, beispielsweise aus gehärtetem Glas, Spezialglas oder hochtemperaturfestem Glas, beispielsweise aus dem Produktportfolio der Anmelderin.

Die Umhäusung kann so gestaltet werden, dass der zumindest eine Funktionsbereich der Umhäusung eingerichtet werden kann zur Aufnahme von zumindest einem Beherbergungs-Objekt. Beherbergungs-Objekte zur Aufnahme in dem zumindest einen Funktionsbereich können beispielsweise eine Größe von 20 mm x 20 mm oder kleiner aufweisen, sie können rund oder oval sein mit einem Durchmesser von beispielsweise 15 mm oder kleiner. Die Beherbergungs-Objekte können auch auch eine Größe von 10 mm x 10 mm oder kleiner, bevorzugt eine Größe von 5 mm x 5 mm oder kleiner, weiter bevorzugt von 2 mm x 2 mm oder kleiner oder auch 1 mm x 1 mm oder kleiner aufweisen. Die Größe der Umhäusung richtet sich dann nach der Größe und Anzahl der Beherbergungs-Objekte in den Funktionsbereichen bzw. Kavitäten der Umhäusung. Beispielsweise bei Anordnung von jeweils einem Beherbergungs-Objekt einer Größe von etwa 5mm x 5mm in jeder von einer Mehrzahl von Kavitäten der Umhäusung, wobei beispielsweise je zwei Kavitäten nebeneinander und je zwei Kavitäten übereinander angeordnet sind, kann eine Umhäusung beispielsweise eine Größe von 13 mm x 13 mm oder größer aufweisen, so dass die Beherbergung der Objekte in den Kavitäten sichergestellt ist.

Die Dicke der Substrate kann etwa 1 mm, etwa 0,7 mm, etwa 0,5 mm, etwa 0,1mm oder dünner sein. Mit anderen Worten liegt die Dicke eines der Substrate der Umhäusung beispielsweise in einem Bereich von kleiner oder gleich 2 mm, bevorzugt kleiner oder gleich 1 mm, weiter bevorzugt kleiner oder gleich 0,5 mm oder kleiner oder gleich 0,1 mm.

Eine Größenangabe aus der Praxis, die sich durch das bevorzugte Herstellungsverfahren bedingt, die jedoch nicht per se als Größenbeschränkung verstanden werden soll, besteht in der Größe der zu schneidenden Wafer. Der Einsatz von Wafern zur Herstellung ist jedoch nur als Beispiel zu verstehen. Es ist durchaus möglich, beispielsweise Glasplatten zur Herstellung der transparenten Umhäusung einzusetzen, die auch größere oder kleinere Abmessungen als typische Wafergrößen aufweisen kann.

Die Sperreinrichtung der Umhäusung umfasst jedenfalls eine Sperrschicht, insbesondere eine Beschichtungslage, welche den Funktionsbereich zumindest teilweise umschließt. Mit anderen Worten kann die Sperreinrichtung als Sperrschicht ausgestaltet sein, die zwischen der Kavität und der die Kavität umgebenden Umhäusung angeordnet ist.

Die Sperrschicht ist bevorzugt an zumindest einem aus Basissubstrat, Abdecksubstrat oder Zwischensubstrat angeordnet, und zwar beispielsweise an der zum Funktionsbereich hin ausgerichteten Innenseite. Die Sperrschicht kann dann ebenfalls von dem Material der Umhäusung geschützt werden. Dies ist dann vorteilhaft, wenn die Sperrschicht als solches beispielsweise nicht dieselbe mechanische oder chemische Widerstandsfähigkeit aufweist, wie das Material des Basis- oder Abdecksubstrats.

Die Sperrschicht kann den Funktionsbereich also unmittelbar umschließen, insbesondere zu zumindest einem der Substrate hin, oder vollständig.

Das Basissubstrat kann aus einem Material vergleichsweise niedriger Permeabilität bestehen. Das Abdecksubstrat kann ein Material umfassen, welches eine höhere Permeabilität aufweist als das Basissubstrat. In diesem Falle ist es vorteilhaft, die Sperreinrichtung zwischen dem Funktionsbereich und dem Abdecksubstrat anzuordnen, wobei der Einsatz der Sperreinrichtung zwischen Kavität bzw. Funktionsbereich und Basissubstrat in diesem Beispiel nicht notwendig wäre.

Die Sperreinrichtung kann Silizium basierte Oxide und/oder Nitride und/oder Oxinitride umfassen, bevorzugt $SiO_2$ und/oder $Si_3N_4$ oder /und auch Aluminium basierte Oxide und/oder Nitride und/oder Oxinitride umfassen, bevorzugt $Al_2O_3$ und/oder AlN. Des Weiteren kann eine Sperrschicht auch Oxide, Nitride oder Oxinitride auf Basis von Silizium und Aluminium, also $SiAl_xN_y$, $SiAl_xO_y$ oder $SiAl_xO_yN_z$ umfassen.

Die Sperreinrichtung kann beispielsweise eine Dicke von 1 $\mu$m oder kleiner, weiter bevorzugt 500 nm oder kleiner, weiter bevorzugt 100nm oder kleiner, besonders bevorzugt 50 nm oder kleiner aufweisen. Die Sperrschicht bzw. Sperreinrichtung kann auch 30 nm oder dünner ausgestaltet sein, um die erfindungsgemäße Wirkung zu erzielen.

Die Sperreinrichtung kann so hergestellt bzw. eingerichtet sein, die Permeabilität zwischen dem Funktionsbereich und der die Umhäusung umgebenden Umgebung mindestens um 30 % zu verringern. Bevorzugt wird die Sperreinrichtung so eingerichtet, dass diese die Permeation um mindestens 50%, ggf. um mindestens 75% senkt. Beispielsweise vermag die Sperreinrichtung die Permeabilität hinsichtlich Wasser bzw. Wasserdampf zu verringern. Die Sperreinrichtung kann die Permeabilität beispielsweise dabei in beiden Durchdringungsrichtungen durch die Sperreinrichtung herabsetzen. Dies bedeutet, dass sowohl Wasserdampf bzw. Gase bzw. Fluide oder allgemein Stoffe, die von der äußeren Umgebung in den Funktionsbereich eindringen wollen, von der Sperreinrichtung abgehalten werden, aber auch Fluide bzw. Stoffe, die aus dem Funktionsbereich in die äußere Umgebung ausdringen wollen. Das "Wollen der Durchdringung des Fluids" wird dabei beispielsweise durch einen osmotischen Druck oder aber durch eine physikalische Druckdifferenz oder eine Überlagerung der beiden Ursachen hervorgerufen, wodurch die Permeabilität definiert wird.

Wenn die Sperreinrichtung eine zweite Sperrschicht aufweist, kann der Funktionsbereich zwischen der ersten Sperrschicht und der zweiten Sperrschicht angeordnet sein. In diesem Beispiel kann die erste Sperrschicht auf dem Abdecksubstrat bzw. an dem Abdecksubstrat angeordnet sein, die zweite Sperrschicht kann an dem Basissubstrat angeordnet sein.

Die zweite Sperrschicht kann andererseits auch auf der ersten Sperrschicht, also auf derselben Seite der Kavität, angeordnet sein wie die erste Sperrschicht. Erste und zweite Sperrschicht können sich hinsichtlich ihrer erreichten Sperrwirkung somit ergänzen.

Gemäß der Erfindung wird auch ein Verfahren zum Bereitstellen einer hermetisch dichten Umhäusung angeeben, wobei von der Umhäusung ein Funktionsbereich, insbesondere eine Kavität, umschlossen wird. Das Verfahren weist die Merkmale des Anspruchs 12 auf..

Das Abdecksubstrat wird mit dem Basissubstrat mittels der Laserbondlinie miteinander gefügt. Mit anderen Worten wird das Abdecksubstrat ohne Zwischenschicht auf oder in das Basissubstrat gesetzt und mit dem Basissubstrat unmittelbar und direkt mit einer oder einer Mehrzahl von gemeinsamen Laserbondlinien miteinander gefügt. In diesem Fall bilden das Abdecksubstrat zusammen mit dem Basissubstrat gemeinsam die vollständige Umhäusung. Mit anderen Worten, es ist kein zusätzliches oder weiteres Teil nötig, um die Umhäusung zu bilden bzw. zu schließen, sondern das Basissubstrat, die zumindest eine Laserbondlinie und das Abdecksubstrat verschließen gemeinsam den Funktionsbereich bzw. die Kavität vollständig und hermetisch dicht. Andererseits kann es vorteilhaft sein, wenn ein oder mehrere Zwischensubstrate eingesetzt werden, beispielsweise um mehrere Kavitäten voneinander zu trennen.

Die zumindest zwei Substrate bzw. das Basissubstrat und das Abdecksubstrat werden so aneinander angeordnet bzw. angebracht, dass sie flächig aneinander zu liegen kommen, ohne dass andere Schichten, Lagen oder Einschlüsse zwischen den zumindest zwei Substraten bzw. zwischen Basissubstrat, Abdecksubstrat und ggf. Zwischensubstrat vorhanden sind. Möglicherweise sind aus technischen Gründen geringste Gaseinschlüsse zwischen den Schichten im Bereich der Kontaktflächen nicht zu vermeiden, die sich auch aus eventuellen Unebenheiten ergeben. Beispielsweise kann durch eine Druckerhöhung, wie insbesondere durch ein Pressen, oder eine Oberflächenbehandlung der Substratschichten, insbesondere der Kontaktflächen, wie einem Schleifprozess, die Menge des im Bereich der flächig aufliegenden Kontaktfläche eingeschlossenen Gases weiter reduziert werden. Das vorherige Evakuieren ist vorteilhaft. Auch eine Befüllung mit einer Gas Art oder auch einer Flüssigkeit kann je nach Prozessparametern und einzusetzenden Materialien vorteilhaft sein.

Es ist besonders bevorzugt, wenn der möglicherweise auftretende Spalt zwischen den Substraten kleiner oder gleich 5 μm dick ist, weiter bevorzugt kleiner oder gleich 1 μm. Dann ist es möglich, mit dem Laser derart zu fügen, dass die Fügezone eine Dicke zwischen 10 bis 50 μm aufweist und eine hermetische Versiegelung sichergestellt ist.

Eine Kontaktfläche muss nicht optisch transparent sein. Weiter ist es vorteilhaft, wenn das transparente Substrat im sichtbaren Wellenlängenbereich opak ausgebildet ist. Lediglich das Substrat, durch welches der Laser durchtritt, um zu der Kontaktfläche zu gelangen, weist zumindest ein spektrales "Fenster" auf, so dass zumindest die Wellenlänge des eingesetzten Lasers durch das Substrat zumindest teilweise oder zumindest bereichsweise hindurchtreten kann. Die Kontaktfläche ist so beschaffen, dass der Laser an dieser eine Energiedeposition vollziehen kann. Beispielsweise können die Oberflächen der beiden aneinander liegenden Substrate angesprengt sein und weiter vorzugsweise eine Rauheit im nm-Bereich aufweisen. An dieser Fläche wird der Laser zumindest teilweise absorbiert, so dass dort Energie eingebracht werden kann. Generell ist eine Kontaktfläche im Sinne dieser Anmeldung als eine Fläche zu verstehen, an welcher der eintreffende Laserstrahl Energie deponieren kann und so ein Fügeprozess entlang einer Linie innerhalb der Kontaktfläche durchgeführt werden kann.

Das Verfahren kann ferner vor dem Schritt Anordnen des Abdecksubstrats auf dem Basissubstrat den weiteren Schritt umfassen: Anordnen der Sperreinrichtung auf dem Abdecksubstrat und/oder auf dem Funktionsbereich.

Der Schritt Bereitstellen des Abdecksubstrats kann das Bereitstellen des bereits mit der Sperreinrichtung ausgerüsteten Abdecksubstrats umfassen, und/oder der Schritt Bereitstellen des Basissubstrats kann das Bereitstellen des bereits mit der Sperreinrichtung ausgerüsteten Basissubstrats umfassen.

Ferner liegt im Rahmen der Erfindung auch die mittels des vorgenannten Verfahrens hergestellte bzw. gebildete Umhäusung.

Zur Bildung der Laserbondlinie wird insbesondere ein Laserstrahl umlaufend um den Funktionsbereich herumgeführt, so dass der Funktionsbereich entlang der zumindest einen Kontaktfläche umlaufend hermetisch verschlossen wird. Gegebenenfalls kann der Laserstrahl mehrfach umlaufend herumgeführt werden und/oder gegebenenfalls eine Mehrzahl von Laserbondlinien ausgebildet werden.

Im Rahmen der Erfindung liegt auch die Verwendung einer nach dem vorstehend beschriebenen Verfahren hergestellten Umhäusung mit darin eingeschlossener hermetisch verschlossenem Funktionsbereich bzw. Kavität als medizinisches Implantat bzw. Bio-Implantat oder als Sensor.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

Kurzbeschreibung der Figuren

Es zeigen:

Fig. 1    Draufsicht auf eine Umhäusung,
Fig. 2    Seiten-Schnittansicht einer Umhäusung,

Fig. 3     Detailansicht auf eine Fügezone,
Fig. 4     Seiten-Schnittansicht durch den Funktionsbereich einer Umhäusung,
Fig. 4a    Seiten-Schnittansicht wie Fig. 4 jedoch mit
           zwei Beherbergungs-Objekten,
Fig. 5     Seiten-Schnittansicht durch eine weitere
           Ausführungsform einer Umhäusung,
Fig. 5a    Seiten-Schnittansicht durch eine weitere
           Ausführungsform einer Umhäusung,
Fig. 6     Seiten-Schnittansicht durch noch eine weitere Ausführungsform einer Umhäusung,
Fig. 6a    Aufsicht auf den Schnitt gemäß Fig. 6,
Fig. 7     Seiten-Schnittansicht durch noch eine weitere Ausführungsform einer Umhäusung,
Fig. 8     Beispiel für Schritte der Herstellung einer
           Umhäusung.

Detaillierte Beschreibung der Erfindung

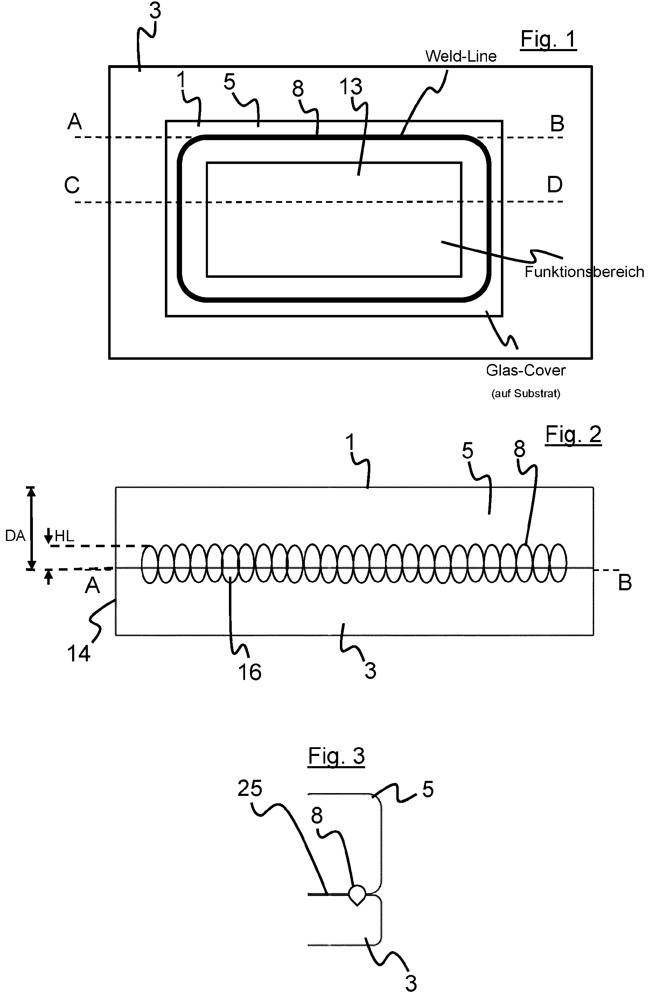

Fig. 1 zeigt eine Draufsicht auf eine Umhäusung 1 gemäß einer Ausführungsform der Erfindung, wobei die umlaufende Laser-Fügezone 8 den Funktionsbereich 13 umgibt. Der Funktionsbereich 13 kann verschieden aufgebaut sein. Beispiele für verschiedenartige Gestaltungen des Funktionsbereichs 13, finden sich auch in den Figuren 3 bis 7, die Schnittansichten zeigen und somit die vertikale Struktur des Funktionsbereichs 13 aufzulösen vermögen. Die verschiedenen Gestaltungen des Funktionsbereichs 13 lassen sich dabei graphisch in der Fig.3 so zusammenfügen, da alle Aufsichten schematisch gleich darstellbar sind. Der Funktionsbereich 13 ist in dem Beispiel der Fig. 1 rechteckig ausgeführt. Je nach dem Verfahren, wie der Funktionsbereich 13 der Umhäusung gebildet wird, kann der Funktionsbereich 13 unterschiedliche Formen annehmen. Beispielsweise können durch abrasive Verfahren hergestellte Kavitäten linsenförmig ausgebildet werden.

Der Funktionsbereich 13 kann verschiedene Aufgaben realisieren, beispielsweise kann dieser als ein optischer Rezeptor ausgestaltet sein, oder ein technisches, optisches, elektromechanisches und/oder elektronisches Bauteil 2 aufweisen, welches im Funktionsbereich 13 angeordnet ist. Es können auch mehrere dieser Aufgaben im Funktionsbereich 13 realisiert werden. Die Umhäusung 1 wird oberseits von dem oberen Substrat oder Abdecksubstrat 5, abgedeckt. Die oder zumindest eine Laser-Fügezone 8 reicht in dieses obere Substrat 5 hinein.

Bezugnehmend auf Fig. 2 ist eine erste Schnittansicht einer ersten Ausführungsform einer Umhäusung 1 gezeigt, welche ein Basissubstrat 3 und ein Abdecksubstrat 5 aufweist. Mit anderen Worten ist die Umhäusung 1 aus zwei Schichten nämlich der Basisschicht 3 und der Abdeckschicht 5 aufgebaut oder zusammengesetzt. Fig. 2 zeigt überdies den Aufbau der Laser-Fügelinie 8 aus einer Aneinanderreihung von einer Mehrzahl von Laser-Pulstrefferbereichen 16, welche so dicht aneinandergesetzt sind, dass das Material des Basissubstrats 3 und des Abdecksubstrats 5 miteinander lückenlos verschmilzt und somit den Funktionsbereich 13 bzw. die Kavität 12 (in dieser Ansicht hinter der Laser-Fügelinie 8 angeordnet) hermetisch verschließt.

Fig. 3 zeigt einen Detailausschnitt auf den Fügebereich, wobei die Interface-Zone, d.h. die Kontaktfläche 25, und die Laser-Fügezone 8 dargestellt sind. Die Laser-Fügezone 8 ist im Bereich der Kontaktfläche 25 angeordnet, um die beiden Substrate 3, 5 miteinander zu fügen.

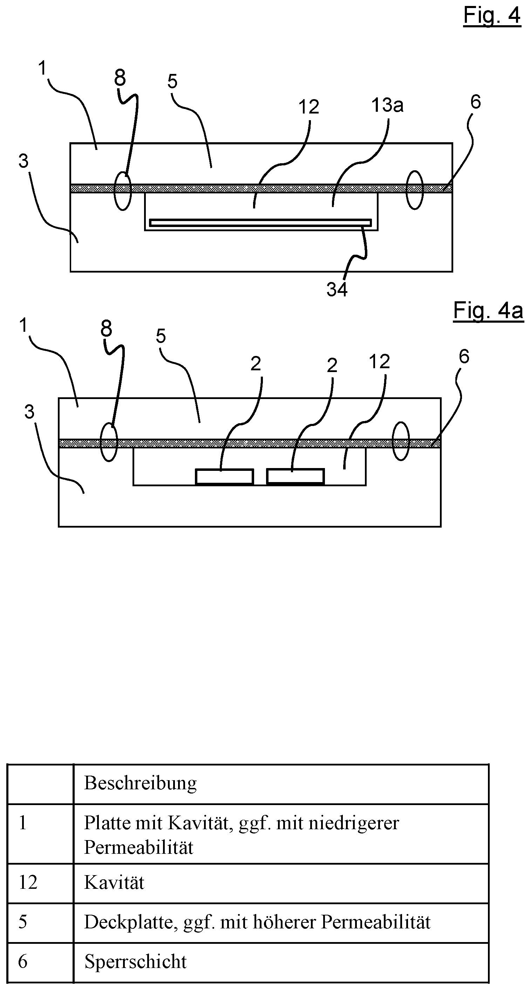

Fig. 4 zeigt eine Schnittansicht einer Ausführungsform einer Umhäusung 1 entlang der Linie C->D, wie sie in Fig. 1 dargestellt ist. Fig. 4 zeigt somit einen Schnitt durch den Funktionsbereich 13, 13a, der sich beispielsweise als durchgehender Hohlraum oder Kavität in der Umhäusung 1 erstreckt. Mit anderen Worten erstreckt sich die Kavität von dem Basissubstrat 3 bis in das Abdecksubstrat 5, und liegt beispielsweise in Form einer Ausnehmung aus Basissubstrat 3 und/oder dem Abdecksubstrat 5 vor. Der Funktionsbereich 13 ist hier als Ausnehmung in dem Abdecksubstrat 5, der Funktionsbereich 13a als Ausnehmung in dem Basissubstrat 3 ausgebildet, beispielsweise mittels eines abrasiven Verfahrens wie einem Sandstrahlverfahren. Mit anderen Worten weist das Basissubstrat 3 eine Vertiefung 13a auf.

Beispielsweise kann der Funktionsbereich 13a eine aktive Schicht umfassen, z.B. eine elektrisch leitfähige Schicht 34. Die aktive Schicht des Funktionsbereichs 13a kann auch einen Photorezeptor umfassen, beispielsweise in der Form einer Photovoltaikzelle, so dass dieser zur Erzeugung von elektrischer Leistung hergerichtet ist. Dann kann es sich bei der Umhäusung 1 um eine autarke Umhäusung 1 handeln.

Umlaufend um den Funktionsbereich 13a ist die Laser-Fügezone 8 angeordnet, mittels welcher der Funktionsbereich 13a an den Seiten rundherum verschlossen ist. Es ist denkbar, in der Laser-Fügezone 8 offene Bereiche zu belassen, so dass der Funktionsbereich 13a nicht rundherum verschlossen ist, beispielsweise um einen Kommunikationskanal oder Platz für eine elektrische Verbindung offenzulassen, mit welchem beispielsweise aber auch eine Fluidkommunikation mit der Umgebung aufbaubar ist. Mit anderen Worten kann vorgesehen sein, vorgeplante Stellen bzw. Positionen nicht mit dem fokussierten Laserstrahl 9 zu verschließen, sondern dort den hermetischen Verschluss mit anderen Mitteln einzurichten. Dies ist jedoch nicht Teil der beanspruchten Erfindung. Bevorzugt ist es allerdings wie auch in Fig. 1 gezeigt, den Funktionsbereich 13, 13a allseits und lückenlos zu verschließen, um den hermetischen Verschluss des Funktionsbereichs 13, 13a sicherzustellen.

In Fig. 4 ist ferner eine erste Ausführungsform einer Sperreinrichtung 6 dargestellt, wobei die Sperreinrichtung 6 an der Unterseite des Abdecksubstrats 5 angeordnet ist und somit unmittelbar an den Funktionsbereich 13a angrenzt. Die Sperreinrichtung der Ausführungsform der Figur 4 verbessert daher die Permeabilität für ein Durchdringen des Abdecksubstrats. In diesem Beispiel weist das Material des Basissubstrats eine niedrigere Permeabilität auf als diejenige des Abdecksubstrats, so dass eine umlaufende Sperreinrichtung 6 bzw. eine allseits den Funktionsbereich 13a verschließende Sperreinrichtung 6 nicht notwendig ist. Es reicht, die Permeation vom Funktionsbereich 13a aus betrachtet in Richtung des Abdecksubstrats 5 zu verringern bzw. zu verbessern.

Fig. 4a zeigt die Ausführungsform der Figur 4, wobei in der Kavität 12 zwei Beherbergungsobjekte 2 angeordnet sind. Bei den Beherbergungsobjekten 2 kann es sich beispielsweise um ein elektronisches Bauteil handeln. Die beiden Ausführungen können auch miteinander kombiniert werden, wenn es sich bei der aktiven Schicht 34 beispielsweise um eine elektrisch leitfähige Schicht 34 handelt, denn dann können die Bauteile 2 auf der leitfähigen Schicht 34 angeordnet und miteinander verbunden werden.

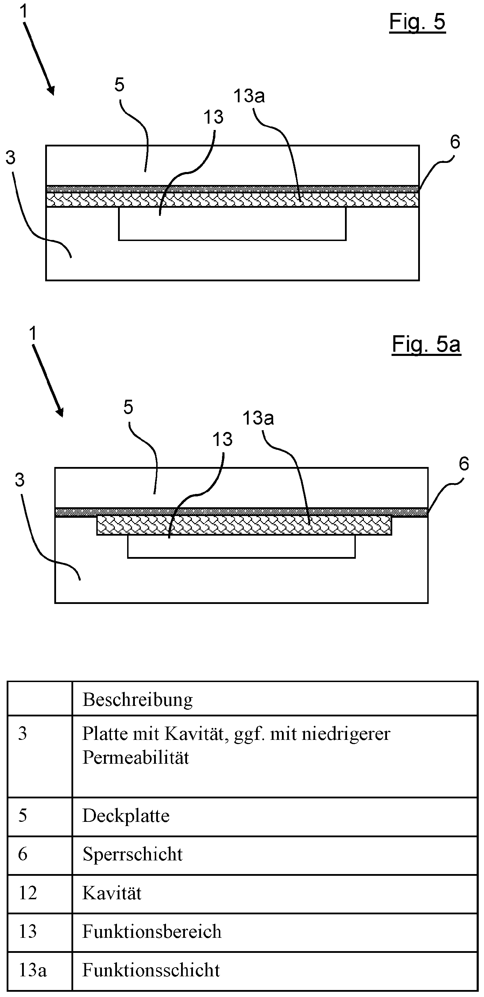

Bezugnehmend auf Figur 5 ist eine weitere Schnittansicht durch eine Umhäusung 1 im Bereich des Funktionsbereichs 13, 13a gezeigt. Die Umhäusung 1 weist zwei Substratlagen auf, nämlich das Basissubstrat 3 das Abdecksubstrat 5. Zwischen dem Basissubstrat 3 und dem Abdecksubstrat 5 ist eine Funktionsschicht 13a vollflächig angeordnet, oberhalb der Funktionsschicht 13a ist die Sperreinrichtung 6 angeordnet.

Zwar ist der Funktionsbereich 13a, hier als Funktionsschicht 13a ausgeführt, somit an zwei bzw. seinen umlaufenden Schmalseiten nicht geschützt, je nach Anwendungsfall und Material der Funktionsschicht 13a kann dies aber tolerabel sein. So zum Beispiel, wenn die Funktionsschicht ein optischer Frequenzfilter oder eine Antireflex-Beschichtung darstellt.

Die Figur 5a zeigt demgegenüber eine Ausführungsform, die der Figur 5 ähnlich ist, wobei die Funktionsschicht 13a in diesem Fall allseits von der Umhäusung umschlossen ist. In diesem Fall, wenn also das Basissubstrat 3 die niedrigere Permeabilität aufweist im Vergleich zum Abdecksubstrat 5, reicht es noch immer aus, wenn die Sperreinrichtung 6 oberhalb der Funktionsschicht 13a in Richtung dem Abdecksubstrat 5 angeordnet ist. Der Funktionsbereich 13 ist als Kavität 12 ausgebildet, wobei in der Kavität 12 ein oder eine Mehrzahl von Bauteilen 2 oder beliebige Beherbergungsobjekte 2, wie auch eine Medikamentendosis 2, angeordnet sein kann.

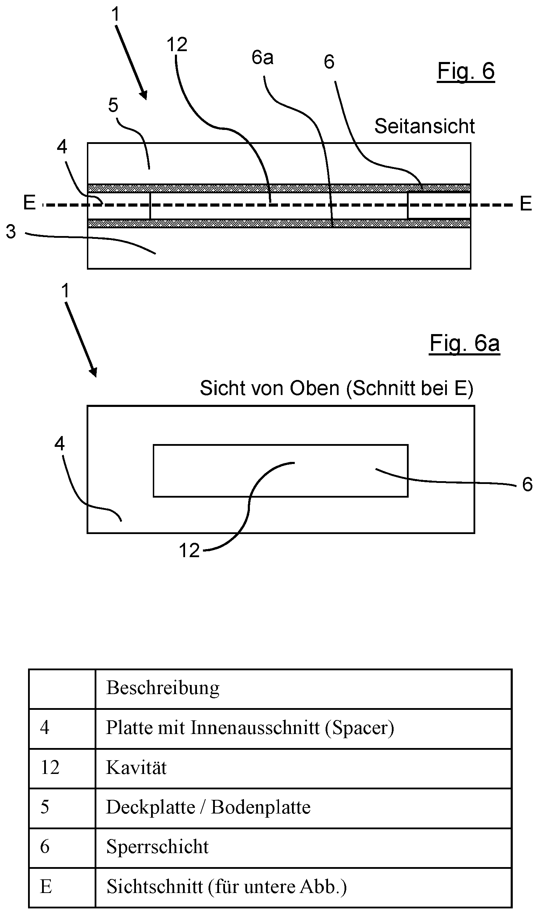

Figur 6 zeigt eine weitere Ausführungsform der erfindungsgemäßen Umbaulösung, wobei die Umhäusung drei Substratschichten, nämlich das Basissubstrat 3, ein Zwischensubstrat 4 sowie das Abdecksubstrat 5 umfasst. Bei dem Zwischensubstrat 4 kann es sich entweder um beispielsweise Abstandsstücke handeln oder es kann sich um ein durchgehendes Substrat handeln, also eine Platte mit Innenausschnitten. Dies wird auch als Spacer 4 bezeichnet.

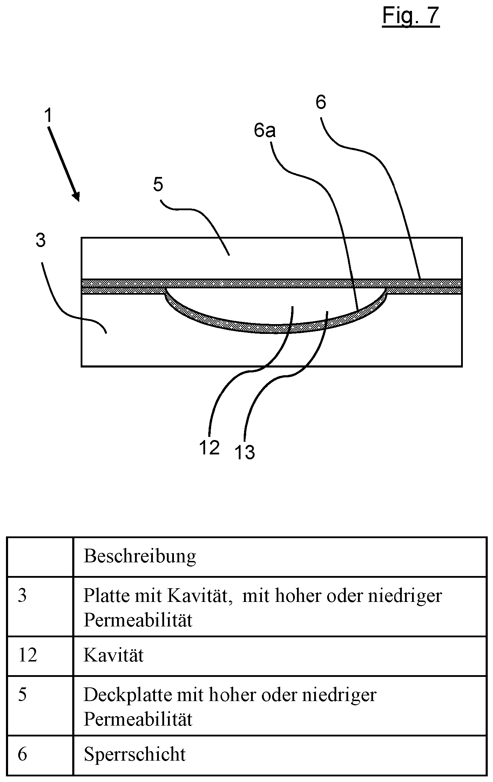

Die Umhäusung der Ausführungsform der Figur 6 weist eine erste Sperreinrichtung 6 auf, die an der Oberseite der Kavität 12 angeordnet ist und somit an der Unterseite des Abdecksubstrats 5. Die Umhäusung 1 weist ferner eine zweite Sperreinrichtung 6a an der Unterseite der Kavität 12 auf, die an der Oberseite des Basissubstrats 3 angeordnet ist. Eine solche Anordnung von zwei Sperreinrichtungen 6, 6a an den beiden Seiten des einzuschließenden Funktionsbereichs 12, 13, 13a kann dann beispielsweise gewählt werden, wenn sowohl das Basissubstrat 3 als auch das Abdecksubstrat 5 eine vergleichsweise hohe Permeabilität aufweisen. In diesem Fall können beide Substrate mittels der Sperreinrichtung 6, 6a gesperrt werden, d. h. die Permeabilität durch das jeweilige Substrat wird gesenkt. In dem Beispiel der Figur 6 schließt die Sperreinrichtung 6, 6a nicht das Zwischensubstrat 4 ein, dies stellt also eine vereinfachte Ausführungsform dar, die in der Herstellung besonders einfach und leicht zu realisieren ist. Je nach Befund der Ausführung des Zwischensubstrats kann es dabei möglich sein, das Zwischensubstrat von der Sperreinrichtung auszusparen, so dass keine komplizierten Aufbringungs- oder Auftragungsvorgänge auf das Zwischensubstrat 4 nötig sind. Aber auch selbst dann, wenn das Zwischensubstrat eine vergleichsweise hohe Permeabilität aufweist, kann es ausreichend sein, lediglich das Basissubstrat 3 und das Abdecksubstrat 5 mit der Sperreinrichtung 6, 6a abzusperren, da die Oberfläche, mit der das Zwischensubstrat 4 mit dem Funktionsbereich 12, 13, 13a in Kontakt steht, vergleichsweise klein ist. Die Diffusion ist dabei abhängig in besonderem Maße von der Größe des Objekts, also der von dem Fluid durchzuströmenden Gases bzw. Fluides. Wenn aber die Oberfläche nur klein ist, wird auch nur wenig Fluid durch das Zwischensubstrat 4 treten, so dass dies je nach Anwendungsfall von der Sperreinrichtung 6, 6a freigelassen werden kann. Andererseits ist auch eine vollständige Schließung des Funktionsbereichs selbstverständlich denkbar, vergleiche Figur 7.

Fig. 6a zeigt die Ausführung von der Figur 6 in einer Schnittansicht um 90° gedreht von oben. Diese Schnittansicht geht also durch das Zwischensubstrat 4 und den als Kavität 12 ausgeführten Funktionsbereich 13 hindurch.

Fig. 7 zeigt noch eine weitere Ausführungsform der Erfindung, wobei der Funktionsbereich 13 abermals als Kavität 12 ausgestaltet ist und eine nicht gerade Unterseite aufweist. Beispielsweise weist die Kavität 12 die Form einer Linse auf, in diesem Fall gezeigt in der Figur 7 als plan-konvexe Linse. Mit anderen Worten ist die Kavität 12 derart eingerichtet, dass in dem Basissubstrat 3 eine konvexe Ausnehmung 12 beispielsweise mittels eines abrasiven Verfahrens ausgehöhlt ist, so dass das Basissubstrat eine konkave Oberseite aufweist. Hierdurch kann eine optische Eigenschaft der Umhäusung entstehen und Auswirkungen für das im Inneren der Kavität 12 angeordnete Beherbergungobjekt 2 (siehe zum Beispiel Figur 4a) haben. Die Umhäusung der Figur 7 weist eine Sperreinrichtung 6 auf, als Sperrschicht ausgeführt. Die Sperrschicht kann als einheitliche umlaufende Sperrschicht um die Kavität 12 herum angesehen werden bzw. ausgeführt werden, diese kann auch in zwei getrennten Verfahrensschritten, zum Beispiel auf die Unterseite des Abdecksubstrats 5, in einer ersten Sperrschicht 6 ausgeführt werden und in einer zweiten Sperrschicht 6a, welche auf die Oberseite des Basissubstrats 3 aufgebracht wird. Es kann sich hierbei also um Beschichtungslagen handeln, die auf das jeweilige Substrat aufgetragen werden. Andererseits kann die Sperreinrichtung 6 auch an dem jeweiligen Substrat angeordnet werden, beispielsweise dort aufgeklebt oder anderweitig angeordnet sein. In dem Beispiel der Figur 7 ist der Funktionsbereich 13 vollständig, d. h. zu allen Seiten hin, von der Sperreinrichtung umschlossen, so dass die Permeation in alle Raumrichtungen verringert ist.

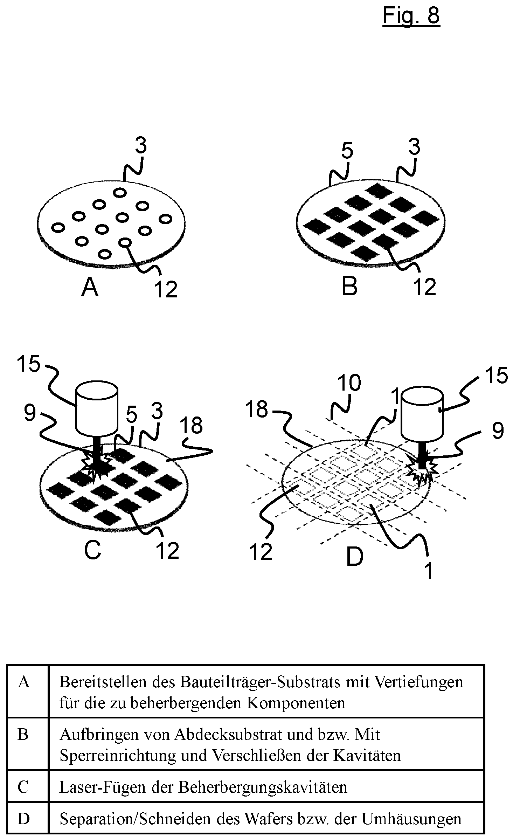

Bezugnehmend auf Fig. 8 ist eine Ausführungsform des Verfahrens zur Herstellung einer Vielzahl von Umhäusungen 1 gezeigt. Es wird die Herstellung der Umhäusungen 1 erläutert, wie sie beispielsweise in den vorstehenden Figuren dargestellt sind. Es ist dem Fachmann klar, dass auch nur eine einzelne Umhäusung 1 mit dem Verfahren hergestellt werden kann, je nach Prozess-Erfordernissen.

In einem Schritt A wird ein gemeinsames Basissubstrat 3 gleichsam als Trägersubstrat bereitgestellt, welches eine Mehrzahl von Vertiefungen 12 aufweist, die den späteren Kavitäten 12 entsprechen, und die beispielsweise mittels eines abrasiven Verfahrens in das Basissubstrat 3 eingebracht wurden. Beispielsweise können die Kavitäten 12 mittels Sandstrahlverfahren in das Basissubstrat 3 eingebracht werden, also aus dem Basissubstrat 3 ausgehöhlt werden, allgemein mit einem abrasiven Verfahren. Auch ein chemisches Ätzen ist möglich, um die Kavität 12 in die Basisschicht 3 einzubringen. In den Vertiefungen 12 können beispielsweise jeweils Beherbergungs-Objekte 2 angeordnet werden, beispielsweise ein Sensor, Aktor, Prozessor oder ein Medikament.

Auf dem Basissubstrat 3 - wie auch auf dem Abdecksubstrat und/oder ggf. auf dem Zwischensubstrat - kann eine Sperreinrichtung 6, 6a angeordnet sein. Beispielsweise in Form einer Beschichtungslage 6. Mittels PVD oder CVD oder anderen Dünnschicht-Beschichtungstechnologien kann beispielsweise mindestens eine Seite eines Substrats 3, 4, 5 bevorzugt kavitätsseitig mit einer dünnen Sperrschicht 6, 6a versehen werden. Diese kann $SiO_2$ umfassen, um bevorzugt die Durchdringung von Wasser bzw. Wasserdampf zu senken. Diese kann auch $Si_3N_4$ umfassen, oder auch $Al_2O_3$ oder auch Al. Andererseits kann die Sperreinrichtung 6, 6a auch auf einem Substrat 3, 4, 5, vorzugsweise auf der dem Funktionsbereich 13, 13a zugewandten Seite, angeordnet sein. Beispielsweise kann eine dünne Schicht bzw. ein dünnes Element dort aufgelegt werden und in Schritt C gemeinsam mit den übrigen Substraten 3, 5 und ggf. 4 gefügt.

In einem Schritt B wird auf dem Basissubstrat 3 ein gemeinsames Abdecksubstrat 5 angebracht, d.h. zu jeder Vertiefung wird eine Kavität 12 erzeugt, indem das Basissubstrat 3 von dem Abdecksubstrat 5 abgedeckt wird, und anschließend mit Schritt C hermetisch gefügt wird. Es können mehrere Beherbergungs-Objekte 2 in jeweils einer gemeinsamen Kavität 12 beherbergt werden.

Mit Schritt C werden die Substrate jeweils unmittelbar mittels Laserbondlinien 8 miteinander gefügt. So können jeweils zwei geschlossen umlaufende Laser-Fügezonen 8 gebildet werden, indem der Laser 9 zweimal um jede Kavität 12 herum entlang der Kontaktflächen 25 bzw. entlang der Außenkanten der Kavitäten 12 geführt wird, jedoch nicht auf exakt identischem Pfad. Vielmehr kann der Laser 9 bei jedem Umlauf um die Kavität 12 auf einem lateral versetzten Pfad geführt werden, so dass zwei nebeneinanderliegende Laser-Fügezonen 8 entstehen. Die Microbonding-Zonen 8 können eine Abmessung von beispielsweise 5μm x 10μm oder kleiner, oder 10μm x 50μm oder kleiner aufweisen.

Es wird also der fertige Substratstapel mittels Laser 9 gefügt, so dass die jeweiligen Beherbergungskavitäten 12 hermetisch verschlossen werden, also das Verschließen der Kavitäten 12 allseits entlang der Kontaktflächen 25 und das Einbringen der zumindest einen Laserbondlinie 8 pro Umhäusung 1. Hierfür wird eine Lasereinheit 15 von oberhalb des Abdecksubstrats 5 über die Oberfläche des Abdecksubstrats 5 geführt und dabei punktuell ein fokussierter Laserstrahl 9 auf die zu fügenden Zonen gerichtet, also insbesondere auf die Kontaktflächen 25. Nach Abschluss des Schritts C des Herstellungsverfahrens sind alle Kavitäten 12 hermetisch geschlossen. Es ist möglich, die einzelnen Umhäusungen 1 nach Schritt C mittels Schneidverfahren zu vereinzeln, und somit einzelne getrennte Umhäusungen 1 zu erhalten.

In Schritt D werden die Bauteile entlang von Trenn- bzw. Schneidlinien 10 voneinander getrennt. Hierfür kann ggf. derselbe Laser eingesetzt werden wie auch für das Laser-Fügen in Schritt C. Es kann aber auch ein herkömmliches Schneidverfahren eingesetzt werden, wenn dies vorteilhaft ist.

Beispielsweise kann der Druck, der sich aufgrund der Permeabilität in der Kavität 12 in Richtung eines Substrats 3, 4, 5 der Umhäusung 1 bzw. in Richtung der Umgebungsbedingungen um die Umhäusung 1 bildet, zusammensetzen als

$$Q = \Delta p \circ \left(1 - e^{-\frac{KA2D}{2DVd+KAd^2}t}\right)$$

wobei D und K von der Temperatur abhängig sind, und wobei

- $\Delta p$ die Partialdruckdifferenz zwischen dem Inneren der Kavität und der Umgebung ist,
- K die Permeabilität angibt,

- D der Diffusionskoeffizient ist,
- A die zu durchdringende Oberfläche der Umhäusung 1 bzw. des entsprechenden Substrats 3, 4, 5 in cm$^2$,
- V das Volumen der Kavität 12 in cm$^3$,
- d die Wandstärke des Substrats 3, 4, 5 bzw. der Umhäusung 1 in cm,
- t die Zeit in Sekunden.

Es ist dem Fachmann ersichtlich, dass die vorstehend beschriebenen Ausführungsformen beispielhaft zu verstehen sind und die Erfindung nicht auf diese beschränkt ist, sondern in vielfältiger Weise variiert werden kann, ohne den Schutzbereich der Ansprüche zu verlassen. In allen Figuren bezeichnen gleiche Bezugszeichen gleiche Merkmale, so dass Beschreibungen von Merkmalen, die ggf. nur in einer oder jedenfalls nicht hinsichtlich aller Figuren erwähnt sind, auch auf diese Figuren übertragen werden können, hinsichtlich welchen das Merkmal in der Beschreibung nicht explizit beschrieben ist.

Bezugszeichenliste:

| | |
|---|---|
| 1 | Umhäusung, insb. hermetisch verschlossen |
| 2 | Beherbergungs-Objekt, Funktionsbaustein |
| 3 | Unteres Substrat, Schicht oder Wafer, Basissubstrat bzw. untere Abdeckung |
| 4 | Zwischenschicht |
| 5 | Oberes Substrat, Schicht oder Wafer, Abdecksubstrat bzw. obere Abdeckung |
| 6, 6a | Sperreinrichtung |
| 8 | Laser-Fügezone |
| 9 | fokussierter Laserstrahl |
| 10 | Trenn- bzw. Schneidlinie |
| 12 | Beherbergungs-Kavität |
| 13 | Funktionsbereich |
| 13a | zweiter Funktionsbereich |
| 14 | Kante |
| 15 | Lasereinheit zum Fügen und/oder Schneiden |
| 16 | Laser-Pulstrefferbereich |
| 18 | Substratstapel |
| 21 | Rand der Kavität |
| 22 | Unterseite der Kavität |
| 23 | Oberseite der Kavität |
| 25 | Kontaktfläche |

**Patentansprüche**

1.  Umhäusung (1) zur Kapselung eines Funktionsbereichs (13, 13a) gegen eine Umgebung, die Umhäusung umfassend:

    ein Basissubstrat (3),
    ein Abdecksubstrat (5), wobei das Basissubstrat zusammen mit dem Abdecksubstrat zumindest einen Teil der Umhäusung oder die Umhäusung bildet,
den zumindest einen in der Umhäusung angeordneten Funktionsbereich,
eine Sperreinrichtung (6, 6a) zur Verringerung der Permeation zwischen der Umgebung und dem Funktionsbereich,
wobei die Umhäusung (1) zumindest eine Laserbondlinie (8) aufweist und die Substrate der Umhäusung mittels der zumindest einen Laserbondlinie hermetisch dicht miteinander gefügt sind,
wobei die Sperreinrichtung zwischen dem Funktionsbereich und dem Abdecksubstrat und/oder zwischen dem Funktionsbereich und dem Basissubstrat angeordnet ist,
wobei die Sperreichrichtung (6, 6a) eine Sperrschicht umfasst, welche den Funktionsbereich zur Umgebung hin zumindest teilweise umschließt, um die Permeation zwischen der Umgebung und dem Funktionsbereich zu verringern.

2.  Umhäusung (1) nach dem vorstehenden Anspruch,

    wobei die Laserbondlinie eine Höhe (HL) senkrecht zu seiner Verbindungsebene aufweist, und/oder
    wobei die Sperrschicht eine Beschichtungslage ist, welche den Funktionsbereich (13, 13a) zumindest teilweise umschließt, und/oder
    ferner umfassend zumindest ein zwischen dem Basissubstrat (3) und dem Abdecksubstrat (5) angeordnetes Zwischensubstrat (4), und/oder
    wobei der Funktionsbereich (13, 13a) zumindest eine Kavität (12) und/oder zumindest eine Funktionsschicht (13a) umfasst.

3.  Umhäusung (1) nach dem vorstehenden Anspruch,

    wobei die Sperrschicht (6, 6a) an zumindest einem aus Basissubstrat (3) und/oder Abdecksubstrat (5) und/oder Zwischensubstrat (4) angeordnet ist, insbesondere an einer zum Funktionsbereich (13, 13a) hin ausgerichteten Innenseite, und/oder
    wobei die Sperrschicht (6, 6a) den Funktionsbereich (13, 13a) unmittelbar umschließt, insbesondere zu zumindest einem der Substrate (3, 4, 5) hin umschließt oder vollständig umschließt.

4.  Umhäusung (1) nach mindestens einem der vorstehenden Ansprüche,

    wobei das Basissubstrat (3) aus einem Material niedriger Permeabilität besteht, und/oder
    wobei das Abdecksubstrat (5) ein Material umfasst, welches eine höhere Permeabilität aufweist als das Basissubstrat.

5. Umhäusung (1) nach mindestens einem der vorstehenden Ansprüche,
wobei die Sperreinrichtung (6, 6a) $SiO_2$ oder $Si_3N_4$ oder $Al_2O_3$ oder AlN umfasst, und/oder

wobei die Sperreinrichtung (6, 6a) ein Metallmaterial umfasst, und/oder
wobei die Sperreinrichtung (6, 6a) $SiO_xN_y$ oder $AlO_xN_y$ umfasst, und/oder
wobei die Sperreinrichtung (6, 6a) $SiAl_xN_y$, $SiAl_xO_y$ oder $SiAl_xO_yN_z$ umfasst.

6. Umhäusung (1) nach mindestens einem der vorstehenden Ansprüche,

wobei die Sperreinrichtung (6, 6a) eine Dicke von $1\mu m$ oder kleiner aufweist, bevorzugt $1\mu m$ oder kleiner, besonders bevorzugt 100nm oder kleiner, besonders bevorzugt 50nm oder kleiner, und/oder.
wobei die Sperreinrichtung (6, 6a) so hergerichtet oder eingestellt ist, die Permeabilität zwischen Funktionsbereich (13, 13a) und Umgebung mindestens um 30% verringert, und/oder
wobei die Sperreinrichtung (6, 6a) die Permeabilität für Wasser bzw. Wasserstoff verringert, und/oder
wobei die Sperreinrichtung (6, 6a) die Permeabilität in beiden Durchdringungsrichtungen durch die Sperreinrichtung bzw. durch das Substrat (3, 4, 5) der Umhäusung herabsetzt.

7. Umhäusung (1) nach einem der vorstehenden Ansprüche 3 bis 6,

wobei die Sperreinrichtung (6, 6a) eine zweite Sperrschicht aufweist, und
wobei der Funktionsbereich (13, 13a) zwischen der ersten Sperrschicht und der zweiten Sperrschicht angeordnet ist.

8. Umhäusung (1) nach mindestens einem der vorstehenden Ansprüche, wobei das Basissubstrat (3) das eine oder die mehreren Zwischensubstrate (4) und/oder das Abdecksubstrat (5) ein glasartiges oder polykristallines Material umfasst, beispielsweise Glas, Glaskeramik, Silizium, Aluminiumoxid, Saphir, Aluminiumnitrid oder einer Kombination der vorgenannten Materialien, und/oder
wobei die Umhäusung (1) zumindest teilweise und/oder bereichsweise für einen Wellenlängenbereich transparent ist..

9. Umhäusung (1) nach mindestens einem der vorstehenden Ansprüche, wobei zumindest eine der Laserbondlinien (8) den Funktionsbereich (12, 13, 13a) in einem Abstand (DF) umlaufend umschließt, und/oder
wobei der Funktionsbereich (12, 13, 13a) hergerichtet ist zur Aufnahme zumindest eines Beherbergungs-Objekts (2), wie beispielsweise ein elektronischer Schaltkreis, ein Sensor oder MEMS, so dass innerhalb der Umhäusung (1) zumindest ein Beherbergungs-Objekt (2) angeordnet ist.

10. Umhäusung (1) nach dem vorstehenden Anspruch, wobei das zumindest eine Beherbergungs-Objekt (2) einen Leistungshalbleiter-Chip, z.B. eine GaN-LED, einen SiC-, GaAs- oder GaN-Leistungstransistor umfasst, und/oder

wobei das Beherbergungsobjekt (2) in einer Kavität (12) angeordnet ist, und/oder
wobei die Umhäusung mehrere Kavitäten (12) umfasst zum Aufnehmen zumindest eines Beherbergungsobjekts (2) in jeweils einer Kavität.

11. Umhäusung (1) nach mindestens einem der vorstehenden Ansprüche,

wobei die Laserbondlinie (8) mit der Höhe (HL) in das Material des über der Laserbondlinie angeordneten Substrats (3, 4, 5) hineinreicht und wobei das Basissubstrat (3) mit dem oder den Zwischensubstraten (4) und dem Abdecksubstrat (5) schmelzend miteinander gefügt ist, und/oder
wobei der zumindest eine Funktionsbereich (13, 13a) der Umhäusung eingerichtet ist zur Aufnahme zumindest eines Beherbergungs-Objekts (2) einer Größe von 10mm x 10mm oder kleiner, bevorzugt einer Größe von 5mm x 5mm oder kleiner, weiter bevorzugt von 2mm x 2mm oder kleiner oder auch 1mm x 1mm oder kleiner, und/oder
wobei die Substrate der Umhäusung mittels anodischem Bonden, Verbindung mit organischem Klebstoff, Glas-Frit-Bonden oder Aufschmelzen mittels CO2-Laser hermetisch dicht miteinander gefügt sind.

12. Verfahren zum Bereitstellen einer Umhäusung (1), wobei von der Umhäusung (1) ein Funktionsbereich (13, 13a), insbesondere eine Kavität (12), umschlossen wird, mit den Schritten:

- Bereitstellen eines Basissubstrats (3) und eines Abdecksubstrats (5), wobei das Abdecksubstrat (5) zumindest teilweise oder bereichsweise zumindest für einen Wellenlängenbereich transparent ist und daher ein transparentes Abdecksubstrat ist,
- Anordnen des Abdecksubstrats (5) auf dem Basissubstrat (3) und oberhalb des Funktionsbereiches, wobei sich zwischen dem Basissubstrat (3) und dem Abdecksubstrat (5) zumindest eine Kontaktfläche (25) ausbildet, so dass jede Umhäusung (1) zumindest eine Kontaktfläche aufweist,

- hermetisch dichtes Verschließen der Kavitäten durch Ausbilden zumindest einer Laserbondlinie (8) entlang der zumindest einen Kontaktfläche jeder Umhäusung (1),

wobei zwischen dem Funktionsbereich und dem Abdecksubstrat und/oder zwischen dem Funktionsbereich und dem Basissubstrat eine Sperreinrichtung angeordnet ist, , die eine Sperrschicht umfasst,

welche den Funktionsbereich zur Umgebung hin zumindest teilweise umschließt, um die Permeation zwischen der Umgebung und dem Funktionsbereich zu verringern.

13. Verfahren nach dem vorstehenden Anspruch,

ferner vor dem Schritt Anordnen des Abdecksubstrats (5) auf dem Basissubstrat (3) mit dem Schritt Anordnen der Sperreinrichtung (6, 6a) auf dem Abdecksubstrat und/oder auf dem Funktionsbereich und/oder auf dem Basissubstrat (3), und/oder

wobei der Schritt Bereitstellen des Abdecksubstrats (5) umfasst Bereitstellen des bereits mit der Sperreinrichtung (6, 6a) ausgerüsteten Abdecksubstrats, und/oder

wobei der Schritt Bereitstellen des Basissubstrats (3) umfasst Bereitstellen des bereits mit der Sperreinrichtung (6, 6a) ausgerüsteten Basissubstrats, und/oder

wobei ein Laserstrahl (9) umlaufend um den Funktionsbereich (12, 13, 13a) herumgeführt wird zur Bildung der Laserbondlinie (8), so dass der Funktionsbereich entlang der Kontaktfläche (25) umlaufend hermetisch verschlossen wird, gegebenenfalls kann der Laserstrahl mehrfach umlaufend herumgeführt werden und/oder gegebenenfalls eine Mehrzahl von Laserbondlinien (8) ausgebildet werden, und/oder

wobei mittels des Verfahrens eine Umhäusung (1) nach einem der Ansprüche 1 bis 19 gebildet wird.

14. Verwendung einer nach dem Verfahren des Anspruchs 12 oder 13 hergestellten Umhäusung (1) mit darin eingeschlossener hermetisch verschlossener Beherbergungs-Kavität (12) als medizinisches Implantat oder als Sensor.

**Claims**

1. An enclosure (1) for encapsulating a functional area (13, 13a) against an environment, the enclosure comprising:

a base substrate (3);

a cover substrate (5), the base substrate together with the cover substrate defining at least part of the enclosure or defining the enclosure;

the at least one functional area provided inside the enclosure;

a blocking means (6, 6a) for reducing permeation between the environment and the functional area;

wherein the enclosure (1) comprises at least one laser bonding line (8) and the substrates of the enclosure are hermetically joined to one another by said at least one laser bonding line;

wherein the blocking means is disposed between the functional area and the cover substrate and/or between the functional area and the base substrate;

wherein the blocking means (6, 6a) comprises a barrier layer enclosing the functional area against the environment at least partially in order to reduce permeation between the environment and the functional area.

2. The enclosure (1) according to the preceding claim,

wherein the laser bonding line has a height (HL) perpendicular to its bonding plane; and/or

wherein the barrier layer is a coating layer which at least partially encloses the functional area (13, 13a) ; and/or

further comprising at least one intermediate substrate (4) disposed between the base substrate (3) and the cover substrate (5); and/or

wherein the functional area (13, 13a) comprises at least one cavity (12) and/or at least one functional layer (13a).

3. The enclosure (1) according to the preceding claim,

wherein said barrier layer (6, 6a) is disposed on at least one of the base substrate (3) and/or the cover substrate (5) and/or the intermediate substrate (4), in particular on an inner side facing the functional area (13, 13a); and/or

wherein the barrier layer (6, 6a) directly encloses the functional area (13, 13a), in particular encloses it against at least one of the substrates (3, 4, 5), or encloses it completely.

4. The enclosure (1) according to at least one of the preceding claims, wherein the base substrate (3) is made of a low permeability material; and/or wherein the cover substrate (5) comprises a material which has a higher permeability than the base substrate.

5. The enclosure (1) according to at least one of the preceding claims,

   wherein the blocking means (6, 6a) comprises $SiO_2$ or $Si_3N_4$ or $Al_2O_3$ or AlN; and/or
   wherein the blocking means (6, 6a) comprises a metallic material; and/or
   wherein the blocking means (6, 6a) comprises $SiO_xN_y$ or $AlO_xN_y$; and/or
   wherein the blocking means (6, 6a) comprises $SiAl_xN_y$, $SiAl_xO_y$, or $SiAl_xO_yN_z$.

6. The enclosure (1) according to at least one of the preceding claims,

   wherein the blocking means (6, 6a) has a thickness of 1 $\mu$m or less, preferably 1 $\mu$m or less, more preferably 100 nm or less, most preferably 50 nm or less; and/or
   wherein the blocking means (6, 6a) is adapted or adjusted so as to reduce the permeability between the functional area (13, 13a) and the environment by at least 30 %; and/or
   wherein the blocking means (6, 6a) reduces the permeability for water and/or hydrogen; and/or
   wherein the blocking means (6, 6a) reduces the permeability in both directions of penetration through the blocking means and through the substrate (3, 4, 5) of the enclosure.

7. The enclosure (1) as claimed in any of the preceding claims 3 to 6,

   wherein the blocking means (6, 6a) comprises a second barrier layer; and
   wherein the functional area (13, 13a) is arranged between the first barrier layer and the second barrier layer.

8. The enclosure (1) according to at least one of the preceding claims,

   wherein the base substrate (3), the one or more intermediate substrates (4) and/or the cover substrate (5) comprise a vitreous or polycrystalline material, for example glass, glass ceramics, silicon, aluminium oxide, sapphire, aluminium nitride, or a combination of the aforementioned materials and/or
   wherein the enclosure (1) is transparent for a range of wavelengths at least partially and/or in portions thereof.

9. The enclosure (1) according to at least one of the preceding claims,

   wherein at least one of the laser bonding lines (8) circumferentially surrounds the functional area (12, 13, 13a) at a distance (DF) therefrom; and/or
wherein the functional area (12, 13, 13a) is adapted to accommodate at least one accommodation item (2) such as an electronic circuit, a sensor, or an MEMS, so that at least one accommodation item (2) is disposed inside the enclosure (1).

10. The enclosure (1) according to the preceding claim,

    wherein the at least one accommodation item (2) comprises a power semiconductor chip, e.g. a GaN LED, a SiC power transistor, a GaAs power transistor or a GaN power transistor; and/or
    wherein the accommodation item (2) is disposed in a cavity (12); and/or
    wherein the enclosure comprises a plurality of cavities (12) for accommodating at least one accommodation item (2) in a respective cavity.

11. The enclosure (1) according to at least one of the preceding claims,

    wherein the laser bonding line (8) extends into the material of the substrate (3, 4, 5) provided above the laser bonding line over a height (HL), and wherein the base substrate (3), the one or more intermediate substrates (4) and the cover substrate (5) are joined together by being fused to one another; and/or
    wherein the at least one functional area (13, 13a) of the enclosure is adapted for accommodating at least one accommodation item (2) having a size of 10 mm x 10 mm or less, preferably a size of 5 mm x 5 mm or less, more preferably 2 mm x 2 mm or less, or even 1 mm x 1 mm or less; and/or
    wherein the substrates of the enclosure are hermetically joined together by anodic bonding, bonding with organic adhesive, glass frit bonding, or by fusing using a $CO_2$ laser.

12. A method for providing an enclosure (1), wherein the enclosure (1) encloses a functional area (13, 13a), in particular a cavity (12), comprising the steps of:

    - providing a base substrate (3) and a cover substrate (5), the cover substrate (5) being transparent for at least one range of wavelengths at least partially or in portions thereof and thus constituting a transparent cover substrate;
    - arranging the cover substrate (5) on the base substrate (3) and above the functional area thereby creating at least one contact area (25) between the base substrate (3) and the cover substrate (5), so that each enclosure (1) has at least one contact area;
- hermetically sealing the cavities by forming at least one laser bonding line (8) along the at least one contact area of each enclosure (1);

wherein a blocking means is disposed between the functional area and the cover substrate and/or between the functional area and the base substrate, which blocking means comprises a barrier layer enclosing the functional area against the environment at least partially in order to reduce permeation between the environment and the functional area.

13. The method according to the preceding claim,

further comprising, prior to the step of arranging the cover substrate (5) on the base substrate (3), a step of arranging the blocking means (6, 6a) on the cover substrate and/or on the functional area and/or on the base substrate (3); and/or wherein the step of providing the cover substrate (5) comprises providing the cover substrate already equipped with the blocking means (6, 6a); and/or
wherein the step of providing the base substrate (3) comprises providing the base substrate already equipped with the blocking means (6, 6a); and/or
wherein a laser beam (9) is directed along the perimeter of the functional area (12, 13, 13a) to form the laser bonding line (8) so that the functional area is hermetically sealed circumferentially along the contact area (25), wherein optionally the laser beam can be directed circumferentially around repeatedly, and/or optionally a plurality of laser bonding lines (8) can be formed; and/or
wherein an enclosure (1) according to any one of claims 1 to 19 is produced by said method.

14. Use of an enclosure (1) produced according to the method of claim 12 or 13, comprising a hermetically sealed accommodation cavity (12) enclosed therein, as a medical implant or as a sensor.

**Revendications**

1. Enceinte (1) destinée au blindage d'une zone fonctionnelle (13, 13a) vis-à-vis d'un environnement, l'enceinte comprenant :

un substrat de base (3),
un substrat de recouvrement (5), le substrat de base formant avec le substrat de recouvrement au moins une partie de l'enceinte ou formant l'enceinte,

la zone fonctionnelle, au nombre d'au moins une, disposée dans l'enceinte,
un dispositif de barrage (6, 6a) destiné à réduire la perméation entre l'environnement et la zone fonctionnelle,
l'enceinte (1) présentant au moins une ligne d'assemblage au laser (8), et les substrats de l'enceinte étant assemblés de façon hermétiquement scellée à l'aide de la ligne d'assemblage au laser, au nombre d'au moins une,
le dispositif de barrage étant placé entre la zone fonctionnelle et le substrat de recouvrement et/ou entre la zone fonctionnelle et le substrat de base,
le dispositif de barrage (6, 6a) comportant une couche de barrage qui entoure la zone fonctionnelle au moins partiellement vis-à-vis de l'environnement, afin de réduire la perméation entre l'environnement et la zone fonctionnelle.

2. Enceinte (1) selon la revendication précédente,

dans laquelle la ligne d'assemblage au laser présente une hauteur (HL) perpendiculairement à son plan d'assemblage, et/ou
dans laquelle la couche de barrage est une feuille de revêtement qui entoure au moins partiellement la zone fonctionnelle (13, 13a), et/ou
comprenant en outre au moins un substrat intermédiaire (4) disposé entre le substrat de base (3) et le substrat de recouvrement (5), et/ou
dans laquelle la zone fonctionnelle (13, 13a) comporte au moins une cavité (12) et/ou au moins une couche fonctionnelle (13a).

3. Enceinte (1) selon la revendication précédente

dans laquelle la couche de barrage (6, 6a) est disposée sur au moins un substrat parmi le substrat de base (3) et/ou le substrat de recouvrement (5) et/ou le substrat intermédiaire (4), notamment sur une face interne tournée vers la zone fonctionnelle (13, 13a), et/ou
dans laquelle la couche de barrage (6, 6a) entoure directement la zone fonctionnelle (13, 13a) et l'entoure vis-à-vis d'au moins un des substrats (3, 4, 5) ou l'entoure complètement.

4. Enceinte (1) selon au moins une des revendications précédentes,

dans laquelle le substrat de base (3) est constitué d'un matériau à faible perméabilité, et/ou
dans laquelle le substrat de recouvrement (5) comporte un matériau dont la perméabilité est supérieure à celle du substrat de base.

5. Enceinte (1) selon au moins une des revendications précédentes, dans laquelle le dispositif de barrage (6, 6a) comporte du $SiO_2$ ou du $Si_3N_4$ ou du $Al_2O_3$ du AlN, et/ou

dans laquelle le dispositif de barrage (6, 6a) comporte un matériau métallique, et/ou
dans laquelle le dispositif de barrage (6, 6a) comporte du $SiO_xN_y$ ou du $AlO_xN_y$, et/ou
dans laquelle le dispositif de barrage (6, 6a) comporte du $SiAl_xN_y$, du $SiAl_xO_y$ ou du $SiAl_xO_yN_z$.

6. Enceinte (1) selon au moins une des revendications précédentes,

dans laquelle le dispositif de barrage (6, 6a) présente une épaisseur de 1 $\mu$m ou moins, de préférence de 1 $\mu$m ou moins, notamment de préférence de 100 nm ou moins, et de manière particulièrement avantageuse de 50 nm ou moins, et/ou
dans laquelle le dispositif de barrage (6, 6a) est agencé ou réglé de manière à ce que la perméabilité entre la zone fonctionnelle (13, 13a) et l'environnement soit réduite d'au moins 30 %, et/ou
dans laquelle le dispositif de barrage (6, 6a) réduit la perméabilité à l'eau, respectivement à l'hydrogène, et/ou
dans laquelle le dispositif de barrage (6, 6a) réduit la perméabilité dans les deux sens de pénétration à travers le dispositif de barrage, respectivement à travers le substrat (3, 4, 5) de l'enceinte.

7. Enceinte (1) selon une des revendications 3 à 6,

dans laquelle le dispositif de barrage (6, 6a) présente une deuxième couche de barrage, et dans laquelle la zone fonctionnelle (13, 13a) est disposée entre la première couche de barrage et la deuxième couche de barrage.

8. Enceinte (1) selon au moins une des revendications précédentes, dans laquelle le substrat de base (3) comporte le substrat intermédiaire (4) ou la pluralité de substrats intermédiaires, et/ou le substrat de recouvrement (5) comporte un matériau de type verre ou polycristallin, par exemple du verre, de la vitrocéramique, du silicium, de l'oxyde d'aluminium, du saphir, du nitrure d'aluminium ou une combinaison des matériaux précités, et/ou
dans laquelle l'enceinte (1) est transparente à une gamme de longueurs d'ondes, au moins en partie et/ou localement.

9. Enceinte (1) selon au moins une des revendications précédentes, dans laquelle au moins une des lignes d'assemblage au laser (8) entoure la zone fonctionnelle (12, 13, 13a) sur la périphérie, à une distance (DF), et/ou
dans laquelle la zone fonctionnelle (12, 13, 13a) est conçue pour accueillir au moins un objet à loger (2), par exemple un circuit électronique, un capteur ou un MEMS, de sorte qu'au moins un objet à loger (2) est disposé à l'intérieur de l'enceinte (1).

10. Enceinte (1) selon la revendication précédente, dans laquelle l'objet à loger (2), au nombre d'au moins un, comprend une puce à semiconducteur, par exemple une DEL GaN ou un transistor de puissance SiC, GaAS ou GaN, et/ou

dans laquelle l'objet à loger (2) est disposé dans une cavité (12), et/ou
dans laquelle l'enceinte comporte plusieurs cavités (12) destinées à accueillir au moins un objet à loger (2), respectivement dans une cavité.

11. Enceinte (1) selon au moins une des revendications précédentes,

dans laquelle la ligne d'assemblage au laser (8) de hauteur (HL) s'étend dans le matériau du substrat (3, 4, 5) disposé au-dessus de la ligne d'assemblage au laser, et dans laquelle le substrat de base (3) est assemblé par fusion avec le ou les substrats intermédiaires (4) et le substrat de recouvrement (5), et/ou
dans laquelle la zone fonctionnelle (13, 13a), au nombre d'au moins une, de l'enceinte est conçue pour accueillir au moins un objet à loger (2) d'une dimension de 10 mm x 10 mm ou moins, de préférence d'une dimension de 5 mm x 5 mm ou moins, de préférence notamment de 2 mm x 2 mm ou moins, voire de 1 mm x 1 mm ou moins, et/ou
dans laquelle les substrats de l'enceinte sont assemblés entre eux de façon hermétiquement scellée, par soudage anodique, assemblage par adhésif organique, assemblage par fritte de verre ou assemblage par fusion au moyen d'un laser CO2.

12. Procédé de mise à disposition d'une enceinte (1), une zone fonctionnelle (13, 13a), notamment une cavité (12), étant entourée par l'enceinte (1), comprenant les étapes suivantes :

- mise à disposition d'un substrat de base (3) et d'un substrat de recouvrement (5), le substrat de recouvrement (5) étant transparent à au moins une gamme de longueurs d'ondes, au moins en partie ou localement, et étant par conséquent un substrat de recouvrement (5) transparent,

- mise en place du substrat de recouvrement (5) sur le substrat de base (3) et au-dessus de la zone fonctionnelle, au moins une surface de contact (25) se formant entre le substrat de base (3) et le substrat de recouvrement (5), de sorte que chaque enceinte (1) présente au moins une surface de contact,

- fermeture hermétiquement scellée des cavités en réalisant au moins une ligne d'assemblage au laser (8) le long de la surface de contact, au nombre d'au moins une, de chaque enceinte (1), sachant qu'il est prévu, entre la zone fonctionnelle et le substrat de recouvrement et/ou entre la zone fonctionnelle et le substrat de base, un dispositif de barrage qui comporte une couche de barrage,

qui entoure au moins partiellement la zone fonctionnelle vis-à-vis de l'environnement, aux fins de réduire la perméation entre l'environnement et la zone fonctionnelle.

13. Procédé selon la revendication précédente,

comprenant en outre, avant l'étape de mise en place du substrat de recouvrement (5) sur le substrat de base (3), l'étape de mise en place du dispositif de barrage (6, 6a) sur le substrat de recouvrement et/ou sur la zone fonctionnelle et/ou sur le substrat de base (3), et/ou

selon lequel l'étape de mise à disposition du substrat de recouvrement (5) comprend la mise à disposition du substrat de recouvrement déjà équipé avec le dispositif de barrage (6, 6a),

selon lequel l'étape de mise à disposition du substrat de base (3) comprend la mise à disposition du substrat de base déjà équipé avec le dispositif de barrage (6, 6a),

selon lequel un faisceau laser (9) est guidé sur le pourtour de la zone fonctionnelle (12, 13, 13a), en vue de former la ligne d'assemblage au laser (8), de sorte que la zone fonctionnelle est hermétiquement scellée sur la périphérie, le long de la surface de contact (25), le faisceau laser pouvant le cas échéant être guidé plusieurs fois le long de la périphérie, et/ou une pluralité de lignes d'assemblage au laser (8) pouvant le cas échéant être réalisées, et/ou

sachant que le procédé permet de réaliser une enceinte (1) selon une des revendications 1 à 19.

14. Utilisation d'une enceinte (1) réalisée suivant le procédé selon la revendication 12 ou 13, comportant une cavité d'accueil (12) hermétiquement scellée, qui y est enfermée, en tant qu'implant médical ou en tant que capteur.

Fig. 1

3

A

1  5  8  13

Weld-Line

B

C

D

Funktionsbereich

Glas-Cover
(auf Substrat)

Fig. 2

1  5  8

DA  HL

A  B

14  16  3

Fig. 3

25  5

8

3

<u>Fig. 4</u>

<u>Fig. 4a</u>

|     | Beschreibung |
| --- | --- |
| 1 | Platte mit Kavität, ggf. mit niedrigerer Permeabilität |
| 12 | Kavität |
| 5 | Deckplatte, ggf. mit höherer Permeabilität |
| 6 | Sperrschicht |

Fig. 5

1

5

13

13a

3

6

Fig. 5a

1

5

13

13a

3

6

| | Beschreibung |
|---|---|
| 3 | Platte mit Kavität, ggf. mit niedrigerer Permeabilität |
| 5 | Deckplatte |
| 6 | Sperrschicht |
| 12 | Kavität |
| 13 | Funktionsbereich |
| 13a | Funktionsschicht |

1

12

6a

6

5

4

E •——————————————————•—————————————————————— E

3

## Fig. 6

Seitansicht

1

## Fig. 6a

Sicht von Oben (Schnitt bei E)

4

12

6

| | Beschreibung |
|---|---|
| 4 | Platte mit Innenausschnitt (Spacer) |
| 12 | Kavität |
| 5 | Deckplatte / Bodenplatte |
| 6 | Sperrschicht |
| E | Sichtschnitt (für untere Abb.) |

## Fig. 7

| | Beschreibung |
|---|---|
| 3 | Platte mit Kavität, mit hoher oder niedriger Permeabilität |
| 12 | Kavität |
| 5 | Deckplatte mit hoher oder niedriger Permeabilität |
| 6 | Sperrschicht |

## Fig. 8

| A | Bereitstellen des Bauteilträger-Substrats mit Vertiefungen für die zu beherbergenden Komponenten |
|---|---|
| B | Aufbringen von Abdecksubstrat und bzw. Mit Sperreinrichtung und Verschließen der Kavitäten |
| C | Laser-Fügen der Beherbergungskavitäten |
| D | Separation/Schneiden des Wafers bzw. der Umhäusungen |

**IN DER BESCHREIBUNG AUFGEFÜHRTE DOKUMENTE**

**In der Beschreibung aufgeführte Patentdokumente**

- EP 3012059 B1
- WO 2008103338 A1
- DE 10235372 A1